# EUROPÄISCHE PATENTSCHRIFT

(11) **EP 0 394 757 B1**
(45) Veröffentlichungstag und Bekanntmachung des Hinweises auf die Patenterteilung: **07.10.1998**
(21) Anmeldenummer: 90106940.1
(22) Anmeldetag: 11.04.1990
(51) Int. Cl.: H01L 21/82, H01L 27/06, H01L 21/027, H01L 21/265, H01L 29/76, H01L 29/10, H01L 23/32, H01L 29/06

(54) **Halbleiterstruktur mit einer 2D-Ladungsträgerschicht und Herstellungsverfahren**
Semiconductor structure with a 2D-charge carrier layer and fabrication method
Structure semi-conductrice avec une couche à porteur de charge bidimensionelle et méthode de fabrication

(30) Priorität: 27.04.1989 DE 3914007; 20.12.1989 DE 3942125; 22.12.1989 DE 3942693
(43) Veröffentlichungstag der Anmeldung: 31.10.1990
(73) Patentinhaber: Max-Planck-Gesellschaft zur Förderung der Wissenschaften e.V., D-37073 Göttingen (DE)
(72) Erfinder: Wieck, Andreas, Dr., D-7032 Sindelfingen (DE); Ploog, Klaus, Dr., D-7000 Suttgart 1 (DE)
(74) Vertreter: Morgan, James Garnet

(56) Entgegenhaltungen:
- PHYSICAL REVIEW B - RAPID COMMUNICATIONS Band 39, Nr. 8, 15. März 1989, Seiten 5535-5537, US; Y. HIRAYAMA et al.: "Electronic transport through very short and narrow channels constricted in GaAs by highly resistive Ga-implanted regions"
- JOURNAL OF VACUUM SCIENCE & TECHNOLOGY B Band 6, Nr. 3, Mai/Juni 1988, Seiten 1014-1017, New York, US; T. HIRAMOTO et al.: "Fabrication of one-dimensional GaAs wires by focused ion beam implantation"
- JOURNAL OF VACUUM SCIENCE & TECHNOLOGY/A Band 4, Nr. 3, Teil 1, Mai/Juni 1986, Seiten 933-938, Woodbury, NY, US; E. MIYAUCHI et al.: "Application of focused ion beam technology to maskless ion implantation in a molecular beam epitaxy grown GaAs or AIGaAs epitaxial layer for three dimensional pattern doping crystal growth"
- IEEE TRANSACTIONS ON ELECTRON DEVICES Band ED-29, Nr. 7, Juli 1982, Seiten 1051-1059; D.C. D'AVANZO: "Proton Isolation for GaAs Integrated Circuits"
- NUCLEAR INSTRUMENTS & METHODS IN PHYSICS RESEARCH Bände 209/210, Teil II, Mai 1983, Amsterdam, NL; X.-C. DENG: "Oxygen Ion Beam Modification of GaAs"
- JAPANESE JOURNAL OF APPLIED PHYSICS Band 29, Nr. 1, Teil 1, Januar 1990, Seiten 48-52, Tokyo, JP; S. NAKATA et al.: "Fabrication of Quantum Wires by Ga Focused-Ion-Beam Implantation and Their Transport Properties"

## Beschreibung

Die vorliegende Erfindung betrifft ein Verfahren zur Erzeugung von aktiven Halbleiterstrukturen mittels Ausgangsstrukturen, welche parallel zur Oberfläche eine 2D-Ladungsträgerschicht aufweisen, sowie Feldeffekttransistoren, die nach diesem Verfahren hergestellt werden. Das Verfahren dient auch zur Herstellung von integrierten bzw. hochintegrierten Schaltungen.

Ein Verfahren bzw. ein Feldeffekttransistor dieser Art ist in dem Aufsatz "Split-Gate Field Effekt Transistor" Appl. Phys. Lett. 54, pages 162 to 164 (1989) von Michael Shur beschrieben worden. Mit diesem Feldeffekttransistor wird versucht, entweder mittels selektiver Elektronenimplantation im Bereich des leitenden Kanals nahe am Drain oder durch Verwendung von getrennten Gate-Elektroden die mittlere Elektronengeschwindigkeit im Kanal zu erhöhen und dadurch den Feldeffekttransistor für den Betrieb bei höheren Frequenzen auszulegen. Die dort beschriebene Technologie erfordert eine relativ komplizierte Fabrikation und die erzeugten Feldeffekttransistoren sind auch nicht für die hohen Betriebsfrequenzen geeignet, die heute nötig sind.

Zusätzlich zu dieser bekannten Technologie ist im Japanese Journal of Applied Physics, 21, L381 (1982) von Herrn Sakaki ein Vorschlag für einen neuartigen Feldeffekttransistor unterbreitet worden, nämlich der sogenannte VMT (velocity-modulation transistor), der eine noch kompliziertere Fabrikation als der Feldeffekttransistor mit getrennten Gate-Elektroden (split gate planar transistor) aufweist und der bis heute noch nicht mit all seinen erwarteten Vorteilen realisiert werden konnte.

Aufgabe der vorliegenden Erfindung ist es, ein Verfahren bzw. einen Feldeffekttransistor der eingangs genannten Art zu schaffen, das bzw. der die Fabrikation wesentlich erleichtert und die Verwendung von aufwendigen Maskensätzen entbehrlich macht, wobei die resultierenden Feldeffekttransistoren wesentlich schneller sind im Vergleich zu den Transistoren, die mit der bekannten Technologie herstellbar sind.

Zur Lösung dieser Aufgabe wird erfindungsgemäß verfahrensmäßig so vorgegangen, wie im kennzeichnenden Teil vom Anspruch 1 beschrieben ist.

Ein nach diesem oder vergleichbarem Verfahren hergestellter Feldeffekttransistor zeichnet sich durch die kennzeichnenden Merkmale von Anspruch 19 aus.

Dieser Feldeffekttransistor stellt gegenüber der gängigen Planartechnologie einen grundsätzlichen Geschwindigkeitssprung nach oben dar. Da die Breite und Dicke des leitenden Kanals in der Größenordnung der Wellenlänge der Ladungsträger liegt, ist eine weitere Verringerung der Gate-Kapazität nicht mehr möglich. Daher ist mit der Realisierung des erfindungsgemäßen IPG-Transistors die fundamentale maximale Grenzfrequenz von Transistoren in Halbleitern erreicht worden.

Versuche sind bereits durchgeführt worden mit Verbindungshalbleitern, basierend auf AlₓGa₁₋ₓAs, wobei die 2D-Ladungsträgerschicht ein 2D-Elektronengas ist.

Das 2D-Elektronengas befindet sich in den untersuchten Proben im Grenzbereich zwischen einer undotierten Al_{0,3}Ga_{0,7}As-Schicht mit einer Dicke von etwa 200 Å (1Å = 10¹⁰ m) und einer undotierten dickeren Schicht aus undotiertem GaAs, wobei die Elektronen aus einer auf der der GaAs-Schicht abgewandten Seite der Al_{0,3}Ga_{0,7}As-Schicht angeordneten dotierten Schicht stammen. Diese dotierte Schicht besteht bei den untersuchten Proben aus einer Schicht aus Al_{0,3}Ga_{0,7} As von etwa 500 Å Dicke, die mit Siliziumatomen in einer Konzentration von etwa 10¹⁸ cm⁻³ n-dotiert ist. Die Grundstruktur selbst wurde mit MBE auf einem Gallium-Arsenid-Substrat mit den üblichen "Mülleimer-Schichten" aufgebaut, wobei die Oberfläche der Ausgangsstruktur in Miller'schen Indizes eine [100]-Fläche ist.

Die linienweise Zerstörung wird nach einer ersten Ausführungsvariante mittels eines fokussierten computergesteuerten Ionenstrahls erzeugt, wobei auch mit relativ geringer Ionenstrahl energie eine ausgeprägte Zerstörung durch die Gesamtdicke der Proben feststellbar ist. Man kann feststellen, daß überall, wo die Zerstörung eingetreten ist, eine hochwertige isolierende Schicht senkrecht zu der Ebene des Halbleiters entstanden ist.

Eine weitere Ausführungsvariante besteht darin, daß man die lateralen Potentialbarrieren durch Ionenimplantation erzeugt. Die so erreichte P-Dotierung bildet mit dem umliegenden Material eine Art n-p-n Grenzflächenanordnung, welche wie zwei entgegengesetzte aneinandergeschlossene Dioden funktioniert und in beide Richtungen einen Stromfluß durch die Grenzflächenanordnung verhindert.

Als weitere Alternative bietet sich die Verwendung eines zumindest im wesentlichen homogenen Ionenstrahls mit ausgedehntem Querschnitt an, welcher durch eine die Linien der erwünschten Zerstörung aufweisende, vorzugsweise aus Metall oder einer dünnen Metallschicht bestehende Maske gerichtet ist. Diese Variante, bietet bei der Herstellung von integrierten oder hochintegrierten Schaltungen besondere Vorteile.

Wenn die lateralen Potentialbarrieren durch Ionenimplantation erzeugt werden, so kann diese Ionenimplantation entweder mittels eines scharf fokussierten Ionenstrahls oder mit einem ausgedehnten Ionenstrahl und einer Maske erfolgen.

Besonders vorteilhaft ist es nach dem Erzeugen der Bereiche mit linienweise zerstörter Leitfähigkeit die Ausgangsstruktur einer Wärmebehandlung auszusetzen, die zu einer teilweisen Ausheilung der Zerstörung und zu einer schärferen Definition der isolierenden Linien führt.

Hierdurch können die leitenden Kanäle nämlich sehr eng produziert und anschließend durch das Ausheilungsverfahren etwas breiter gemacht werden, wodurch eine sehr hohe Bauelementdichte auf der Ausgangsstruktur erreichbar ist.

Die bis jetzt durchgeführten Gleichstromexperimente zeigen, daß die Gates elektrisch isoliert sind und daß Leckströme, wenn überhaupt vorhanden, im Piko-Ampere-Bereich liegen. Die Gate-Spannung Vg wird ohne erkennbaren Einsatz von Leckströmen bis ± 20V variiert, wahrscheinlich kann noch bei deutlich höheren Spannungen gearbeitet werden. Der Kanalwiderstand R beträgt bei z.B. einer Elektroneneinzelschicht (HEMT) typischerweise 5 kOhm bei Vg =0 V und ändert sich proportional 1 : (Vg - Vₜₕ), wobei der Kanal bei der Threshold-Spannung Vₜₕ = -11 V vollständig abgeschnürt ist (R > 1 GOhm). Diese Daten änderten sich nur wenig mit der Temperatur T und sind bei T = 4.2 K und T = 300 K im Dunkeln (Abwesenheit von Bandgap-Strahlung) gemessen worden.

Mit dem erfindungsgemäßen Verfahren kann man nicht nur hochwertige Feldeffekttransistoren herstellen, es ist auch mit relativ geringem Aufwand durchzuführen, vorausgesetzt, daß man über eine computergesteuerte, scharf fokussierbare Ionenstrahlquelle verfügt oder die oben erwähnte Verfahrensvariante mit einer Maske und einem ausgedehnten Ionenstrahl anwendet. Nach dem Aufwachsen der Ausgangsstrukturen mittels MBE, das zeitlich entkoppelt von der Herstellung der Feldeffekttransistoren stattfinden kann, werden mittels des fokussierten Strahles der eingeschlossene Gate-Elektrodenbereich sowie die Drain- und Source-Elektrodenbereiche auf der Ausgangsstruktur eingeschrieben. Diese Bereiche können dann kontaktiert werden durch das übliche Eindiffundieren von Kontaktmaterial, wodurch ein hochwertiger niederohmiger Kontakt zu dem 2D-Elektronengas in den einzelnen voneinander isolierten Bereichen erreicht wird. Die genaue Lage der eindiffundierten Kontakte ist völlig unkritisch, da das 2D-Elektronengas in den einzelnen Bereichen dafür sorgt, daß die angelegten Spannungen über den gesamten Bereich verteilt sind. Somit ist die Herstellung eines einzelnen Feldeffekttransistors mit nur einer einfachen Maske für die Kontaktierung der einzelnen Bereiche möglich, wobei auch hier keine besonderen Vorkehrungen getroffen werden müssen, um sicherzustellen, daß die Kontakte genau plaziert sind.

Bei der Herstellung von einzelnen Feldeffekttransistoren auf einzelnen Halbleiterplättchen ist die Linienführung des fokussierten Ionenstrahls noch einfacher, da die Seitenkanten des Plättchens, d.h. die seitliche Begrenzung desselben, auch zur Umschließung des eingeschlossenen Bereiches herangezogenen werden können, d.h. die isolierten Linien müssen nur von einem Teil der seitlichen Begrenzung zu einem anderen laufen.

Zur Bildung des leitfähigen Kanals reicht es vollständig aus, eine einzelne isolierende Linie in das Plättchen einzubringen, wesentlich ist aber, daß das Ende der Linie einem ausgedehnten Seitenbereich oder Eckbereich des eingeschlossenen Gate-Elektrodenbereiches gegenüberliegt, um einen einwandfreien elektrischen Kanal zu definieren.

An dieser Stelle soll darauf hingewiesen werden, daß man versucht hat, eine Kanalstruktur mittels zwei eingeschriebener isolierender Linien auf einer typischen Ausgangsstruktur zu erzeugen. Diese Arbeit ist in Physical Review B, Vol. 39, Nr. 8 vom 15. März 1989 beschrieben worden und zwar in einem Aufsatz von Y. Hirayama, T. Saku und Y. Horikoshi mit der Bezeichnung "Electronic Transport through very Short and Narrow Channels Constricted in GaAs by Highly Resistive Ga Implanted Regions". Hier liegen aber zwei Linien einander ausgerichtet gegenüber, so daß nur ein kleiner Spalt zwischen den Enden der beiden einander gegenüberliegenden Linien existiert. Mit den untersuchten Proben war es jedoch nicht möglich, definierte und reproduzierbare Meßwerte zu erreichen, außerdem ist kein FET realisiert worden.

In weiterer Ausgestaltung des erfindungsgemäßen Verfahrens kann die genannte Linie, die den Source- und den Drain-Elektrodenbereich voneinander trennt, einen einer Seite des rechteckigen Gate-Elektrodenbereiches bzw. dessen Ecke gegenüberliegenden abgewinkelten Abschnitt aufweisen, der mit dieser Seite den Kanal seitlich begrenzt.

Diese Ausbildung hat den eminenten Vorteil, daß zwischen dem abgewinkelten Abschnitt und dem rechteckigen Eckbereich ein geometrisch einwandfrei definierter Kanal entsteht, wobei nur eine einzige Gate-Elektrode erforderlich ist.

Es ist aber auch möglich, die genannte Linie so zu führen, daß ein zweiter eingeschlossener Gate-Elektrodenbereich entsteht. Diese Ausführung ist zwar ungünstig für Anwendungen, wo die gleiche Gate-Spannung an beide Gates angelegt werden soll, da man dann eine externe leitende Verbindung zwischen den beiden Gate-Elektroden braucht. Es ist aber auch möglich, die zu erzeugende Struktur mit unterschiedlichen Gate-Spannungen an den beiden Gate-Elektroden zu betreiben (wobei die eine Spannung negativ, die andere Spannung positiv sein kann), was zu einem asymmetrischen Potential im Kanal führt, wodurch die Ladungsträger in Richtung der anziehenden Spannung gezogen werden, wodurch eine geringere Mobilität und daher auch ein höherer Kanalwiderstand erreicht wird. Für kleine Gate-Spannungsunterschiede wird erwartet, daß die Änderung in den Ladungsträgerdichten klein ist, wodurch diese einfache Struktur sich auch bestens für einen VMT (velocity modulated transistor) eignet. Aufgrund der beiden Gate-Elektroden kann diese allgemeine Struktur auch für ein schnelles logisches Gatter verwendet werden.

Für einfache Transistoranwendungen bei integrierten Schaltkreisen ist die bisher beschriebene Ausführung bevorzugt, wo die dem geschlossenen Gate-Elektrodenbereich gegenüberliegende Linie selbst keinen geschlossenen Gate-Elektrodenbereich umgrenzt. In diesem Fall ergibt sich eine Struktur mit drei Anschlüssen, wobei man sich diese Struktur auch so vorstellen kann, daß eine zweite Gate-Elektrode vorhanden, jedoch durch eine interne Verbindung mit der Source-Elektrode kurzgeschlossen ist.

Eine besonders bevorzugte Ausführungsform ist im Anspruch 26 angegeben. Der so resultierende Kanal ist sehr kurz und hat daher eine niedrige effektive Kapazität und einen niedrigen Widerstand, so daß das Bauteil bestens für hohe Betriebsfrequenzen beispielsweise oberhalb von 1THz geeignet ist.

Eine weitere bevorzugte Ausführung, die zur Vermeidung von Überhitzung wichtig ist, ist im Anspruch 27 beschrieben.

Um einen niedrigen Ausgangswiderstand der Einrichtung zu erreichen, der für den Betrieb bei Hochfrequenzen besonders wichtig ist, kann diese planare Gate-Elektroden-Struktur auch bei Multischichten realisiert werden, die mit der herkömmlichen Planar-Gate-Technologie nicht leicht zu verarmen sind.

Das erfindungsgemäße Verfahren ist weiterhin keinesfalls auf die Herstellung von einzelnen Feldeffekttransistoren begrenzt. Beispielsweise ist es durchaus möglich, durch entsprechende linienweise Zerstörung der Ausgangsstruktur diese in eine integrierte oder hochintegrierte Schaltung umzuwandeln, wobei zusätzlich zu der Erzeugung von aktiven Halbleiterelementen auch passive Schaltungselemente beispielsweise in Form von Widerständen und Induktivitäten durch entsprechende Linienführung des ionisierenden Strahls erzeugt werden können. Einen Widerstand kann man beispielsweise durch einen langen, relativ engen Kanal und einen Induktor durch eine sinus- oder mäander- bzw. rechteckwellenförmige Führung zweier parallel zueinander angeordneten Linien erzeugen.

Die Herstellung von integrierten oder hochintegrierten Schaltungen nach dem erfindungsgemäßen Prinzip, ist deshalb so attraktiv, weil die sonst erforderlichen höchstpräzisen Masken sowie die verschiedenen unterschiedlichen Herstellungsschritte weitestgehend vermieden werden. Es ist lediglich erforderlich, den fokussierten Ionenstrahl entsprechend der erwünschten Schaltung zu führen, wobei die integrierte Schaltung sozusagen in einem Herstellungsschritt in die Ausgangsstruktur, d.h. in den Ausgangschip eingeschrieben wird. Selbst bei Verwendung einer Maske und eines ausgedehnten Ionenstrahles zur Erzeugung der erwünschten linienweisen Zerstörung ist nur eine einzige Maske für die gesamte Schaltung erforderlich (zuzüglich einer weiteren Maske für die Kontaktierung der mit der ersten Maske erzeugten Elektrodenbereiche).

Die Verwendung des erfindungsgemäßen Verfahrens zur Herstellung von integrierten Schaltungen bietet im Prinzip auch die Möglichkeit, Kreuzverbindungen herzustellen und zwar dadurch, daß die Halbleiterstruktur wenigstens zwei parallel zu der Oberfläche liegende und voneinander in Richtung senkrecht zu der Oberfläche einen Abstand aufweisende 2D-Ladungsträgerschichten hat, und daß die Kontaktierung und linienweise Zerstörung so vorgenommen wird, daß elektrische Verbindungen zwischen den 2D-Ladungsträgerschichten entstehen und das Isolationsschreiben in verschiedenen Tiefen (erreichbar durch verschiedene Ionenenergie) kreuzweise erfolgt.

Weitere bevorzugte Ausführungsformen des erfindungsgemäßen Verfahrens bzw. der erfindungsgemäßen Feldeffekttransistoren sind den Unteransprüchen zu entnehmen.

Die Erfindung wird nachfolgend anhand von Ausführungsbeispielen unter Bezugnahme auf die Zeichnung näher erläutert, welche zeigt:
- Fig. 1: einen Querschnitt durch eine Ausgangsstruktur, die sich für die Herstellung der erfindungsgemäßen Feldeffekttransistoren bzw. integrierte Schaltungen eignet,
- Fig. 2: ein Band-Diagramm des aktiven Bereiches der Ausgangsstruktur der Fig. 1,
- Fig. 3: eine schematische Draufsicht auf eine Ausgangsstruktur, so wie die der Fig. 1, die zur Bildung eines Feldeffekttransistors mittels eines fokussierten Ionenstrahls behandelt worden ist,
- Fig. 4: eine Draufsicht entsprechend der Fig. 2, jedoch von einer abgewandelten Ausführungsform,
- Fig. 5: ein Diagramm des Kanal-Widerstandes als Funktion der angelegten Gate-Spannung bei der Ausführung gemäß Fig. 3, bei der an beiden Gate-Bereichen die gleiche Spannung liegt,
- Fig. 6: ein herkömmliches Schaltbild eines Zweistufen-Transistorverstärkers, und
- Fig. 7: eine Draufsicht auf eine Ausgangsstruktur gemäß Fig. 1, auf der die äquivalente integrierte Schaltung des zweistufigen Verstärkers der Fig. 6 mittels eines fokussierten Ionenstrahls eingeschrieben worden ist.
- Fig. 8: eine schematische Draufsicht auf eine alternative Ausführung eines FET's auf einer Ausgangsstruktur gemäß Fig. 1,
- Fig. 9: eine schematische Darstellung eines Querschnittes durch den Kanal der Fig. 8,
- Fig. 10: oben ein Diagramm des Gate-Widerstandes als Funktion der angelegten Gatespannung bei der Ausführung gemäß Fig. 8 bei der das eine Gate an die Source angeschlossen war,

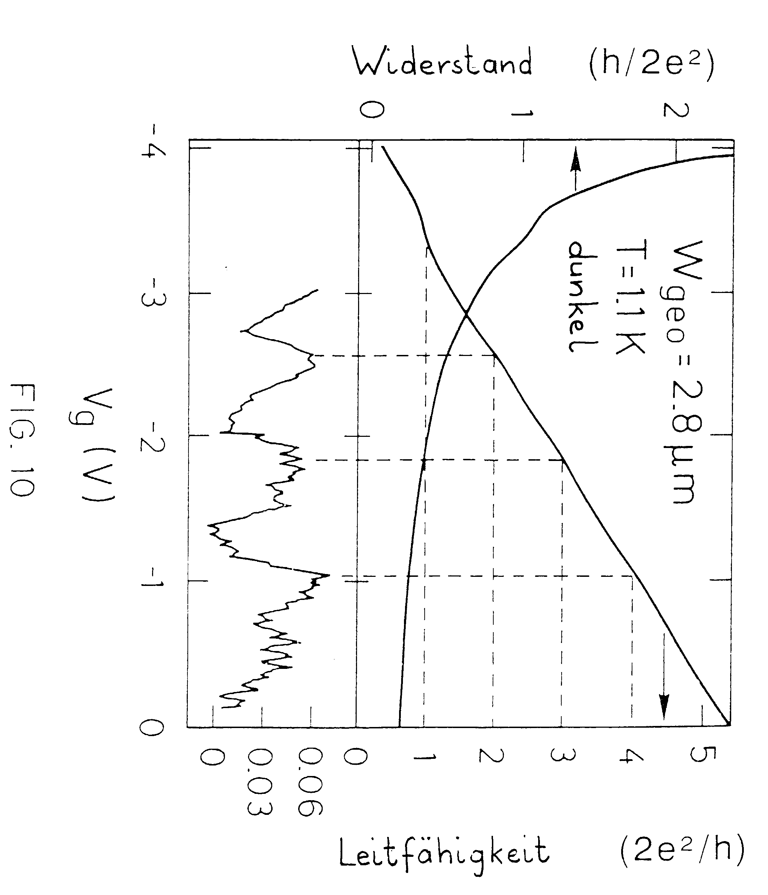

- Fig. 10: unten die Abweichungen der in Fig. 10 oben gezeigten Leitfähigkeit von einer geraden Linie.

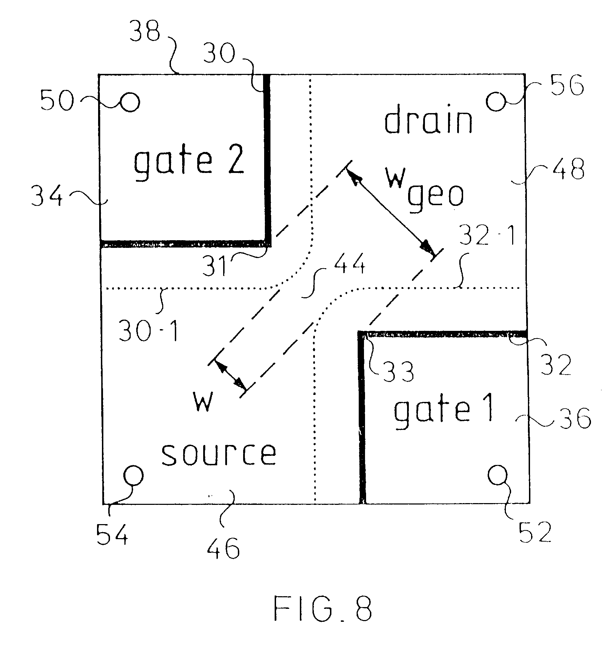

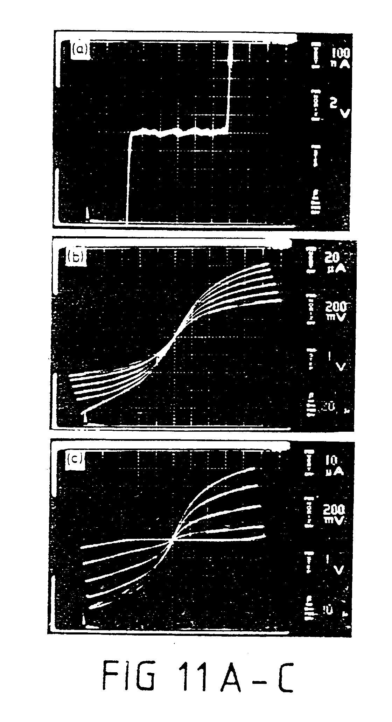

- Fig. 11a-c: Strom-Spannungs(I-V)-Kennlinie eines IPG-Transistors nach Fig. 8 mit W_{geo} = 5.2µm bei T = 77K, a) zeigt die IV-Kennlinie zwischen Gate und Kanal, bei -5.6V≤V_{g}≤5.6V sind die Gates vom Kanal isoliert, b) zeigt I-V-Kennlinien des Kanals für verschiedene positive V_{g}, wobei der Mittelpunkt des Diagramms der Koordinatenursprung ist. Die Kurve mit den kleinsten absoluten Ordinatenwerten entspricht V_{g}=0V, die darüberliegenden entsprechen positiven V_{g} in jeweils 1V-Schritten (V_{g}=1,2,3,4,5V), in c) werden IV-Kennlinien wie in b) gezeigt, jedoch für negative V_{g}. Die Kurve mit den größen absoluten Ordinatenwerten entspricht V_{g}=0V, die darunterliegenden V_{g}=-1,-2,-3,-4V,

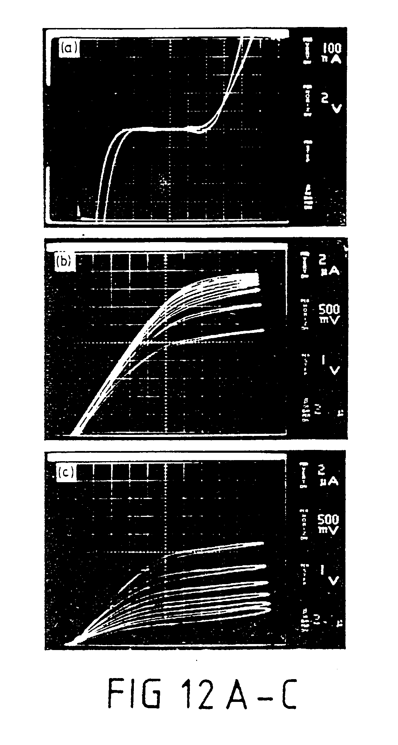

- Fig. 12a-c: I-V-Kennlinien wie in Fig. 11a-c, jedoch bei Raumtemperatur gemessen. In b) und c) ist der Koordinatenursprung in der linken unteren Ecke des Diagramms. Die Doppellinien und leichten Schleifen sind Artefakte des Kennlinienschreibers,

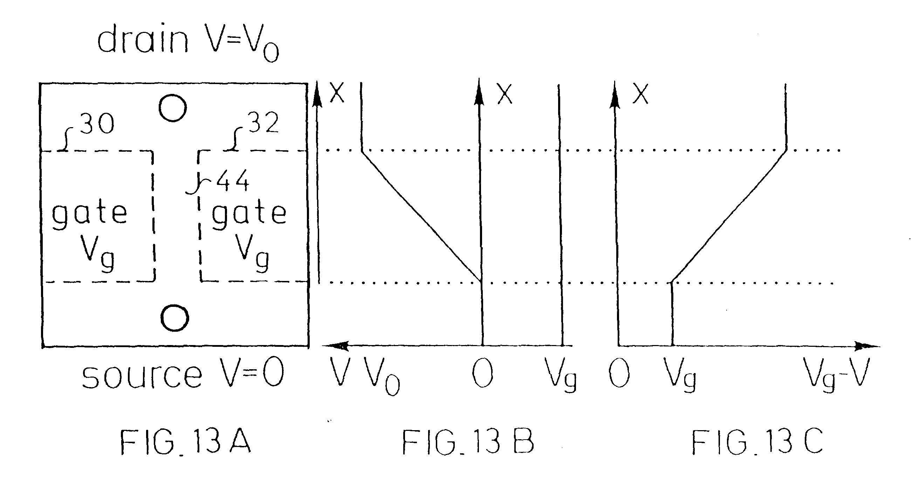

- Fig. 13A: eine Draufsicht auf eine alternative Ausführung eines erfindungsgemäßen FET,
- Fig. 13B: eine Darstellung des Verlaufs der Spannungsverteilung entlang der X-Richtung in Fig. 13A,
- Fig. 13C: eine schematische Darstellung der die Stärke des E-Feldes bestimmenden Spannung V_{g}-V in der Richtung X in Fig. 13A,

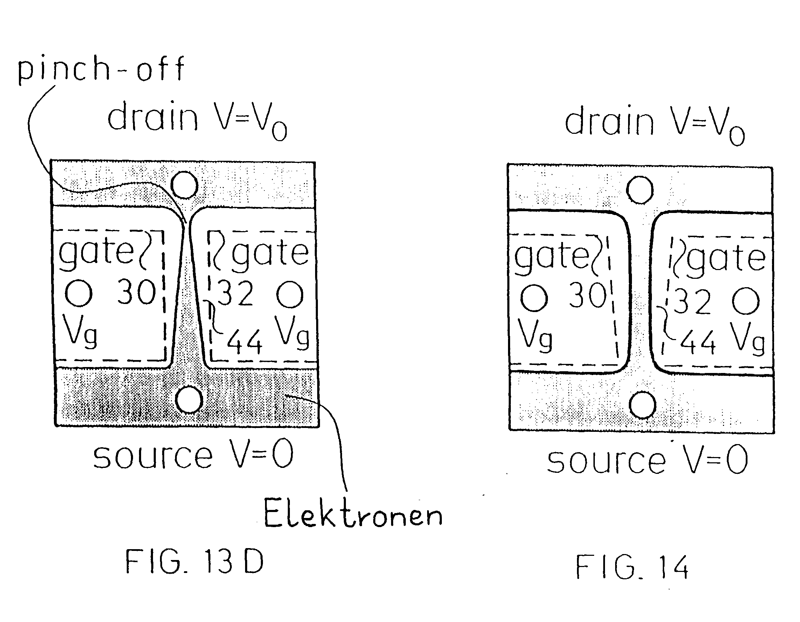

- Fig. 13D: die Einschnürung des Kanals, verursacht durch die Spannungsverteilung gemäß Fig. 13C,
- Fig. 14: eine im Vergleich zu Fig. 13A bessere Gestaltung der den Kanal bildenden Seiten der Gateelektroden-Bereiche eines erfindungsgemäßen FET's,

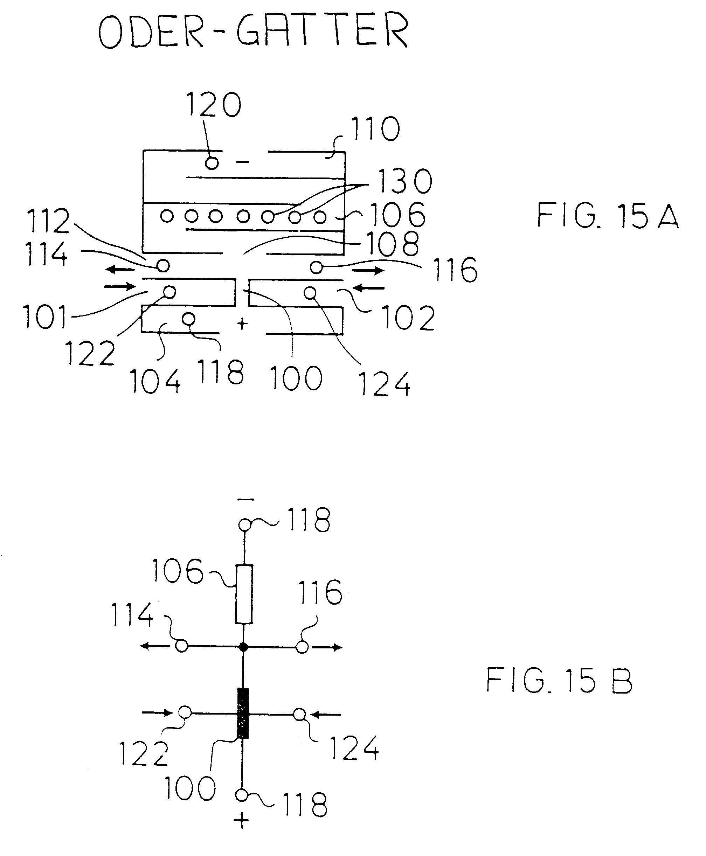

- Fig. 15A: ein nach der Erfindung hergestellter ODER-Gatter,
- Fig. 15B: das equivalente Schaltbild für den ODER-Gatter der Fig. 15A,

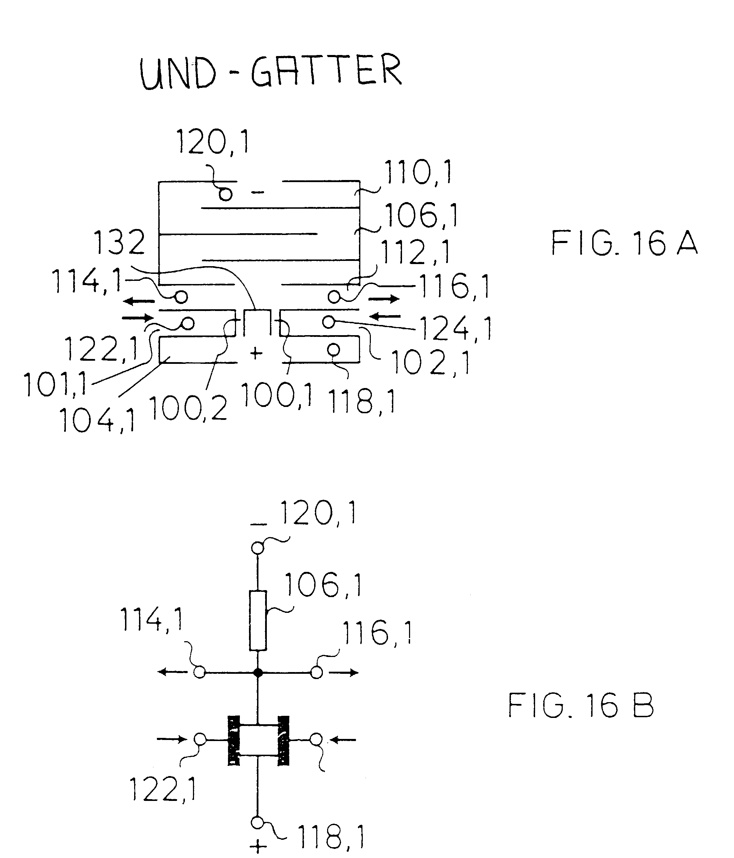

- Fig. 16A: ein nach der Erfindung hergestellter UND-Gatter,
- Fig. 16B: das equivalente Schaltbild für den UND-Gatter der Fig. 16A.

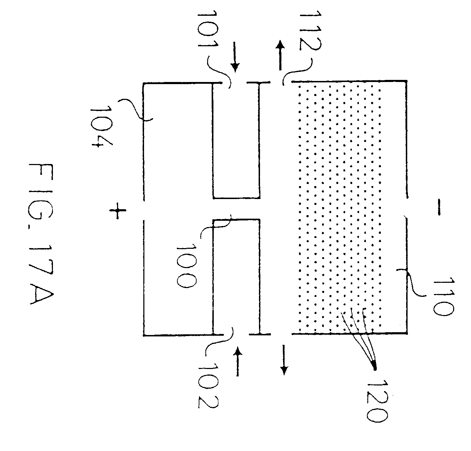

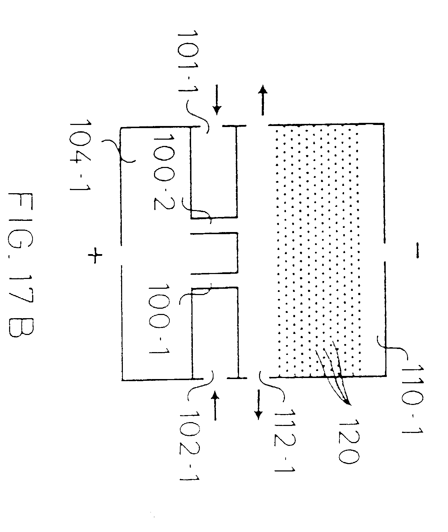

- Fig. 17A und B: eine alternative Version des ODER-Gatters und des UND-Gatters der Fig. 15A bzw. 16A.

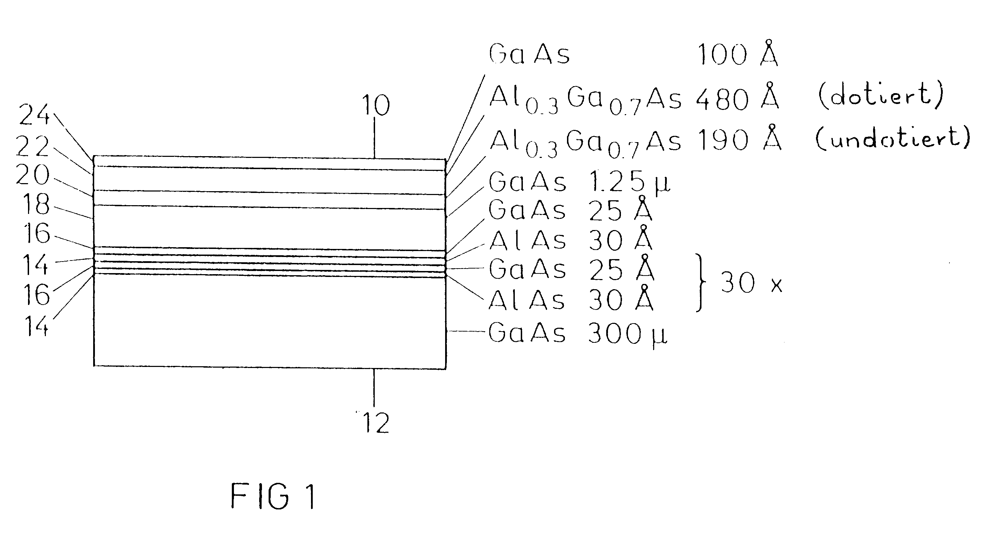

Zunächst zeigt die Fig. 1 eine Halbleiterstruktur eines Verbindungshalbleiters auf der Basis AlₓGa₁₋ₓAs. Diese Struktur ist so aufgewachsen, daß die Oberfläche 10 in Miller'schen Indizes eine [100]-Fläche ist. Die Struktur besteht aus einem Gallium-Arsenid-Substrat von etwa 300 µm Dicke, das undotiert ist. Auf dieses Substrat werden dann etwa 20 Perioden alternierende undotierte AlAs- und GaAs-Schichten 14, 16 aufgewachsen, wobei der Darstellung halber nur vier solche Perioden gezeigt sind. Diese Schichten bilden die sogenannten Mülleimerschichten, die im Substrat enthaltene Verunreinigungen an den Grenzflächen zurückhalten, so daß die oberen Mülleimerschichten relativ sauber bleiben. Die einzelnen Mülleimerschichten sind etwa 30 Å dick, (AlAs 30Å, GaAs 25Å).
Auf diesen Schichten wird dann eine Schicht aus undotiertem Gallium-Arsenid aufgewachsen mit einer Dicke von etwa 1.25 µ. Gefolgt wird diese Schicht 18 durch eine Schicht aus Al_{0,3}Ga_{0,7}As von etwa 190 Å Dicke, wobei auch diese Schicht undotiert ist. Auf dieser undotierten Schicht 20 wird dann eine weitere Schicht 22 von dotiertem Al_{0,3}Ga_{0,7}As von etwa 480 Å aufgewachsen, wobei die Dotierung mittels Siliziumatomen vorgenommen wird und zwar mit einer Dotierungsdichte von etwa 10¹⁸ cm⁻³.

Die Struktur wird dann mit einer letzten Gallium-Arsenidschicht 24 von etwa 100 Å abgeschlossen, wobei auch diese Schicht undotiert ist.

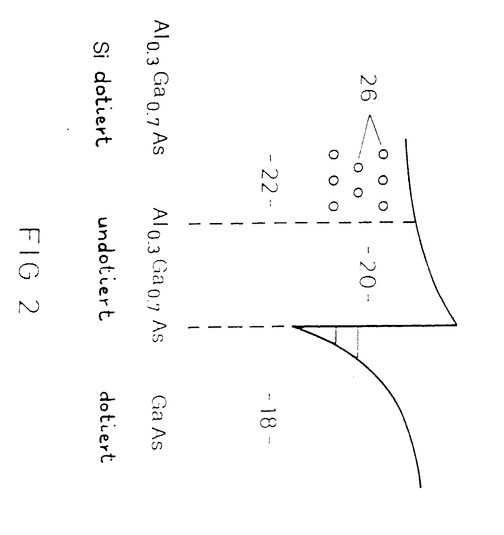

Die Bandstruktur des aktiven Bereiches der Ausgangsstruktur der Fig. 1 ist in der Fig. 2 gezeigt. Man sieht deutlich aus diesem Banddiagramm, daß sich ein Quantentopf im Grenzbereich der Al_{0,3}Ga_{0,7}As-Schicht 20 und der GaAs-Schicht 18 bildet und daß die räumlich von diesem Quantentopf getrennten Silizium-Donatoratome 26 dazu dienen, Elektronen in das quantisierte Energieniveau innerhalb des Quantentopfes zu plazieren. Die Elektronen erreichen dieses Energieniveau dadurch, daß sie durch die Al_{0,3}Ga_{0,7}As-Schicht 20 tunneln.

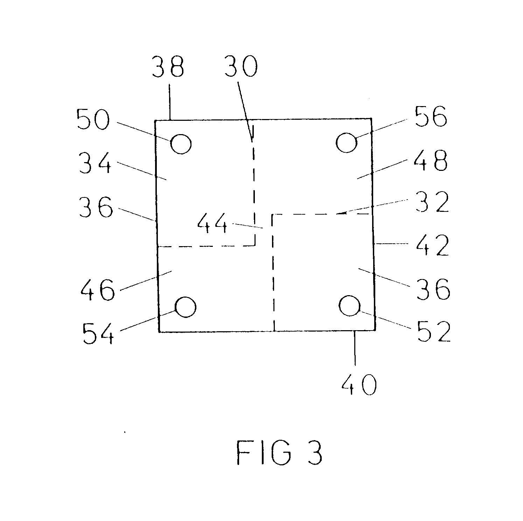

Zur Bildung des Feldeffekttransistors der Fig. 3 wird mittels eines fokussierten Ionenstrahls aus Galliumionen (Ga+) mit einem Strahlfokus von 0,1 µm, einer Strahlenergie von 100 keV und einer Stromdichte von 10 mA/mm² in einer Vakuumkammer eine linienweise Zerstörung der Ausgangsstruktur bewirkt. Hierdurch entstehen linienförmige isolierte Bereiche 30, 32, die in diesem Beispiel beide rechtwinklig verlaufen und das Plättchen mit einer Seitenlänge von 100 µm in einen Source-, einen Drain-, einen Kanal- und zwei Gate-Bereiche unterteilen. Man kann sich die linienweise Zerstörung so vorstellen, daß die Linien die Oberkanten von isolierenden Mauern sind, die sich senkrecht zu der Oberfläche der Ausgangsstruktur, durch die gesamte Struktur hindurcherstrecken. Somit umschließt die Linie 30 einen geschlossenen Gate-Elektrodenbereich 34, und die Linie 32 einen geschlossenen Gate-Elektrodenbereich 36. Umschlossen werden diese Bereiche in diesem Beispiel nicht nur von den Linien 30 und 32, sondern auch von den Randbereichen 36 und 38 bzw. 40 und 42 des Plättchens.

Zwischen den beiden Gate-Bereichen ist ein Kanalbereich 44 definiert, der sich von einem Source-Bereich 46 bis zu einem Drain-Bereich 48 erstreckt.

Die Bereiche 34, 36, 46 und 48 werden dann mit eindiffundierten metallischen Kontakten 50, 52, 54 und 56 versehen, welche die externen Anschlüsse des Feldeffekttransistors darstellen. Da in jedem Bereich ein 2D-Elektronengas vorhanden ist, das sich über die gesamte Breite des Bereiches erstreckt, werden an den kontaktierten Bereichen angelegte Spannungen auch über den gesamten jeweiligen Elektrodenbereich angebracht.

Nach dem Einschreiben der isolierenden Linien sollen die Feldeffekttransistoren erfindungsgemäß im Dunkeln gehalten werden.

Die Breite des leitenden Kanals 44 zwischen den beiden Gate-Elektrodenbereichen ist im vorliegenden Beispiel etwa 5 µm, in der Praxis sind noch kleinere Bereiche denkbar, sogar Breiten unter 1 µm.

Wie vorhin erwähnt, kann der Feldeffekttransistor der Fig. 3 so betrieben werden, daß die beiden Gate-Elektrodenbereiche 34 und 36 durch eine externe leitende Verbindung miteinander gekoppelt sind. Man kann aber auch unterschiedliche Gate-Spannungen an die Gate-Elektroden anlegen, mit den ebenfalls vorher beschriebenen Vorteilen.

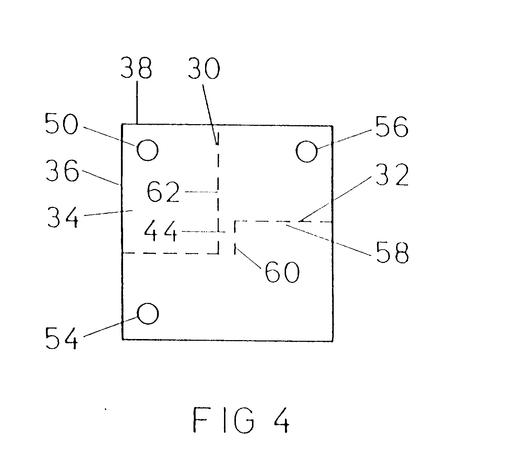

Die Struktur der Fig. 3 läßt sich noch weiter vereinfachen, was in der Fig. 4 gezeigt ist.

Hier ist die Linie 30 genauso geführt wie in der Ausführung der Fig. 3, die Linie 32 ist jedoch nunmehr so ausgebildet, daß sie aus einem ersten Abschnitt 58 besteht, der sich bis zu der rechten Seite des Plättchens erstreckt, und aus einem abgewinkelten Abschnitt 60, der parallel zu der Seite 62 des rechteckigen Gate-Bereiches verläuft. Der leitende Kanal 44 wird hier zwischen dem abgewinkelten Abschnitt 60 und der Seite 62 des geschlossenen Gate-Elektrodenbereiches 34 definiert. Kontaktiert wird dieser Feldeffekttransistor nunmehr nur an drei Stellen 54, 50 und 56, um elektrische Anschlüsse zu Source, Gate und Drain zu erzeugen.

Es ist auch möglich, die Linie 32 als einfache Linie auszubilden, so daß das Ende der Linie punktförmig der Seite oder der Ecke des angeschlossenen Gate-Elektrodenbereiches 34 gegenüberliegt. Die Linie, die in diesem Fall der Linie 58 entsprechen würde, muß auch nicht so angeordnet werden, wie in Fig. 3 gezeigt, sie könnte beispielsweise von der unteren rechten Ecke des Plättchens bis kurz vor der Ecke des eingeschlossenen Gate-Bereiches 34 gezogen werden.

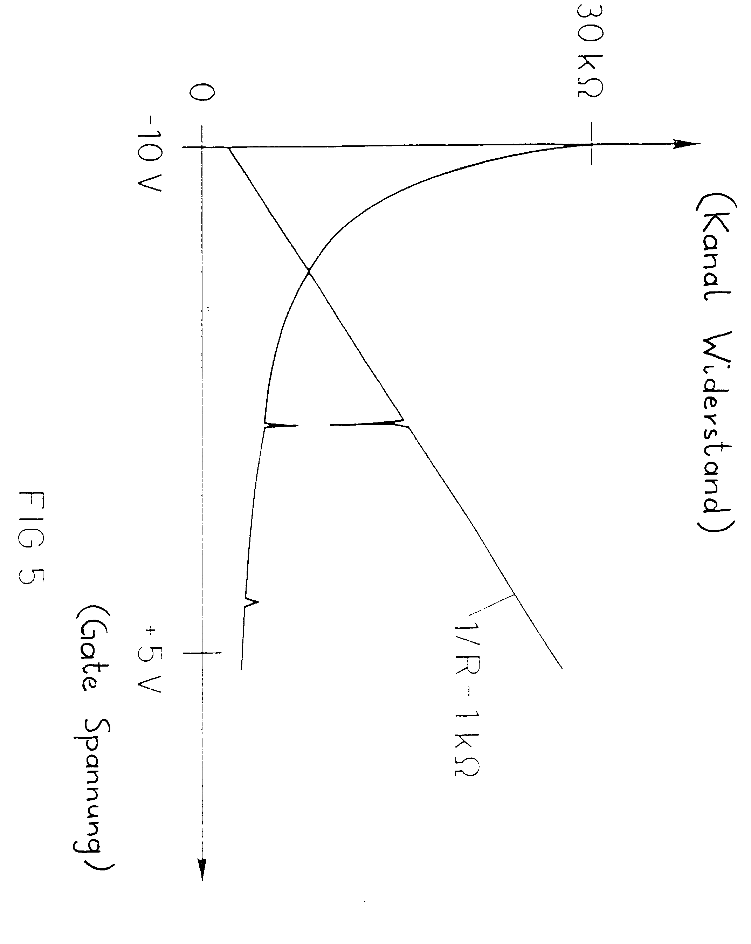

Fig. 5 zeigt ein Diagramm 64 des Kanal-Widerstandes als Funktion der Gate-Spannung bei der Ausführung der Fig. 3. Bei der entsprechenden Untersuchung wurden beide Gate-Elektroden 34 und 36 miteinander verbunden, so daß die gleiche Gate-Spannung an den beiden Gate-Elektroden angelegt wurde.

Die gezeigten Spitzen 66 gehören nicht zu dem gemessenen Verlauf, sie wurden durch das Einschalten von anderen elektrischen Geräten verursacht.

Zusätzlich zu dem etwa hyperbolischen Verlauf des Gate-Widerstandes als Funktion der angelegten Gate-Spannung zeigt das Diagramm eine zumindest im wesentlichen gerade Linie 68, die von unten links bis oben rechts verläuft. Hier ist der reziproke Widerstand, die Kanalleitfähigkeit, als Funktion der angelegten Gate-Spannung gezeigt, wobei der Widerstand der Zuleitungen, in diesem Fall 1 kOhm, berücksichtigt worden ist. D.h., die gerade Linie zeigt einen Wert 1/(R-1 kOhm). Die strenge Linearität des reziproken Widerstandwertes belegt die ausgezeichneten Eigenschaften des Feldeffekttransistors.

Fig. 6 zeigt ein herkömmliches Schaltbild eines zweistufigen Verstärkers, der aus zwei Feldeffekttransistoren 70 und 72 sowie zwei Widerständen 74 und 76 gebildet ist. Die Source 78 des Feldeffekttransistors 70 sowie die Source 80 des zweiten Feldeffekttransistors 72 sind an der positiven Klemme 82 zusammengeschlossen. Der Drain 84 des ersten Feldeffekttransistors 70 ist über den Widerstand 74 an der negativen Klemme 86 und ebenfalls an die Gate-Elektrode 88 des zweiten Feldeffekttransistors 72 angeschlossen. Der Drain 90 des zweiten Feldeffekttransistors 72 ist in entsprechender Weise über den Widerstand 76 an die negative Klemme 86 angelegt. Ein zu verstärkendes Signal wird am Eingang des Schaltkreises an die Gate-Elektrode 92 des ersten Feldeffekttransistors 70 angelegt und das verstärkte Ausgangssignal wird von dem Drain 90 des zweiten Feldeffekttransistors 72 erhalten.

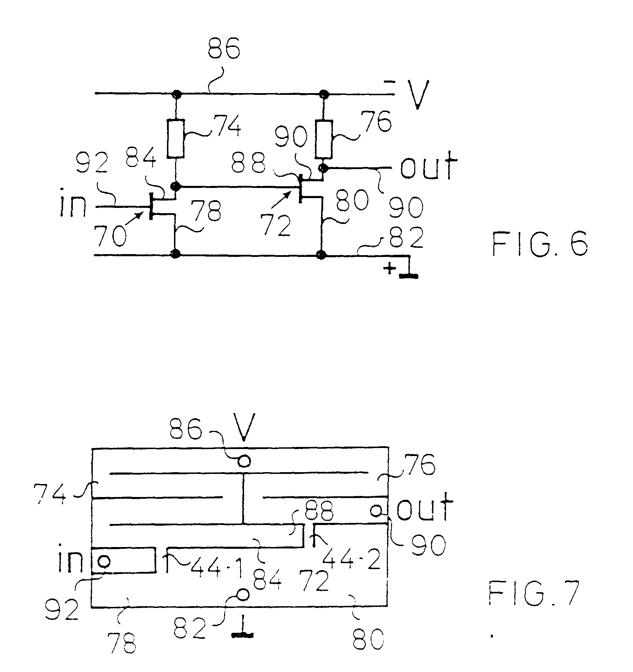

Fig. 7 zeigt, wie dieser zweistufige Verstärker mittels des erfindungsgemäßen Verfahrens auf einem einzigen Chip realisiert werden kann. Zum leichteren Verständnis sind die einzelnen Bezugszeichen des Ersatzschaltbildes der Fig. 6 in die Zeichnung der Fig. 7 eingetragen, und die Fig. 7 ist waagerecht mit der Fig. 6 ausgerichtet und hat in senkrechter Richtung den gleichen Maßstab. Linien deuten in Fig. 6 leitende Verbindungen an, während sie in Fig. 7 isolierende Bereiche symbolisieren. Der Chip hat in diesem Fall eine rechteckige Form, wobei alle Linien, die innerhalb der seitlichen Begrenzung des rechteckigen Chips 94 liegen, durch einen fokussierten Ionenstrahl auf die bisher beschriebenen Art und Weise eingeschrieben worden sind. Der Bereich 78, 80 stellt einen gemeinsamen Source-Bereich dar, der bei 82 kontaktiert ist. D.h., die positive Spannung wird bei 82 angebracht und aufgrund des 2D-Elektronengases an die miteinander verbundenen Source-Bereiche 78 und 80 verteilt. Die negative Klemme ist bei 86 in der Mitte des oberen Feldes des Chips angelegt. Die Eingangsspannung wird bei 92 angelegt und das Ausgangssignal bei 90 extrahiert. Der Bereich 84 stellt die Drain-Elektrode des ersten Feldeffekttransistors 70 dar, der leitende Kanal 44.1 ist zwischen den beiden einander eng gegenüberliegenden isolierenden Linien zwischen den Bezugszeichen 92 und 84 definiert. Der Drain-Bereich 84 führt nach links bis zu der linken seitlichen Begrenzung des Chips, dann nach rechts bis zur Mitte des Chips, dann wieder nach links und wieder nach rechts bis zu der Anschlußklemme 86. Die Breite dieses gesamten Weges ist so ausgelegt, daß hierdurch ein Widerstand 74 entsteht. Die beiden eng beieinanderliegenden parallelen Linien auf der rechten Seite des Chips liegen zwischen dem Bezugszeichen 84 und 90 und stellen den Kanal 44.2 des zweiten Feldeffekttransistors 72 dar. Auch der Drain 90 des zweiten Feldeffekttransistors 72 ist mit dem negativen Anschluß 86 über einen mäanderförmigen Weg verbunden, der den Widerstand 76 darstellt und entsprechend dem Widerstand 74 ausgelegt ist (jedoch spiegelsymmetrisch hierzu). Aufgrund dieser mäanderförmigen Wege sind beide Widerstände in diesem Beispiel mit Induktivität behaftet.

Mit der Erfindung wird ein unipolares Elektronikbauelement mit quasi-eindimensionalem Trägerkanal vorgeschlagen, das alle Eigenschaften eines FET besitzt. Dieses Bauelement läßt sich sehr einfach herstellen, besitzt "self alignment" und lineare statt planare Gates mit sehr geringer Kapazität. Dadurch ist sehr hohe Betriebsfrequenz möglich. Die Struktur besteht aus einer anfangs homogenen 2D-Schicht mit hoher Trägerbeweglichkeit, die durch Epitaxie an z.B. GaAs erzeugt wird. Implantierung von beschleunigten fokussierten Ionen (z.B. Ga⁺ mit 100 keV) zerstört örtlich die Leitfähigkeit der Elektronenschicht. Die bestrahlten Bereiche bleiben auch nach Beleuchtung des Kristalls mit Bandlückenstrahlung bei niedriger oder Raumtemperatur isolierend. Dieses Einschreiben der Isolationsschicht wird längs zwei Wegen (30, 32) an dem Plättchen durchgeführt, so daß die 2D-Trägerschicht in drei voneinander isolierte Bereiche unterteilt ist. Source und Drain sind nur durch einen engen Kanal (44) verbunden, dessen Breite durch eine Gate-Spannung kontinuierlich abstimmbar ist, die gleichzeitig an den beiden Gate-Bereichen (34, 36) bezüglich der Source angelegt ist, so daß sich eine starke Änderung der Trägerkonzentration und damit des Kanalwiderstandes ergibt.

Bei dem Bauelement besteht das elektrische Einschnürungsfeld parallel zur 2D-Schicht und der zerstörte isolierende Bereich dient als Dielektrikum. Durch Erhöhen einer negativen in der Ebene liegenden Gate-Spannung überwindet die Ausdehnung des elektrischen Feldes rasch den zerstörten nahezu isolierten Bereich neben dem durch Ionenstrahl betroffenen Weg. Die Träger werden so auf einen quasieindimensionalen Kanal des anfangs qualitativ hochwertigen Plättchens begrenzt, und die Gate-Spannung beeinflußt nur die Ladungsträgerdichte, jedoch nicht die hohe Beweglichkeit. Das kann sehr wichtig für ballistischen Transport sein, wo große freie mittlere Weglänge gefordert ist.

Nachfolgend wird die Erfindung in weiteren Details erläutert, mit besonderer Betonung auf erfindungswesentliche wichtige technologische und wissenschafliche Aspekte.

Die gegenwärtige Technologie von Feldeffekt-Transistoren stützt sich ausschließlich auf den "planaren" Feldeffekt, d.h. das die elektronisch leitende Schicht beeinflussende Gate bildet mit der ersteren einen Plattenkondensator. Erst in jüngerer Zeit wird in der Grundlagenforschung das inhomogene Streufeld an den Rändern solcher Gates benützt, um quasi-eindimensionale Kanäle zu erzeugen. Der Nachteil dieser Oberflächengates ist, daß die inhärenten Kapazitäten groß und damit die maximalen Arbeitsfrequenzen begrenzt sind. Außerdem ist die Herstellung von solchen lateral begrenzten Schichtstrukturen relativ kompliziert, insbesondere die sub-µm-präzise Positionierung von Source und Drain relativ zum Gate. Der hier vorgestellte IPG-Transistor weist diese Nachteile nicht auf und ist zudem in einem einzigen Technologieschritt ohne Masken und chemische Prozesse schnell herzustellen. Dadurch entfallen die Positinierungsprobleme vollständig.

Grundlage der Herstellung der neuen Struktur ist das lateral lokale Passivieren ("Isolationsschreiben") der Leitfähigkeit einer ursprünglich homogenen elektronischen Schicht an der Grenzfläche einer vorzugsweise Al_{0.3}Ga_{0.7}As - GaAs Heterostruktur. In einer solchen Heterostruktur führt die Energieband-Diskontinuität zwischen dem Al_{0.3}Ga_{0.7}As und dem GaAs bei geeigneter Dotierung zu einer Bandverbiegung, in der sich eine Elektronenrandschicht dicht unter der Kristalloberfläche ausbildet. Diese Elektronenrandschicht ist mit deiner Dicke von 10 nm (was etwa der De Broglie-Wellenlänge der Elektronen entspricht) so dünn, daß Quanteneffekte senkrecht zu ihr wichtig werden und man von einem zweidimensionalen Elektronengas (2DEG) spricht. Das Isolationsschreiben in das 2DEG kann z.B. mit einem fein fokussierten Ga⁺-Ionenstrahl (Focused Ion Beam, FIB) mit 100 keV Energie, 100 nm Fokusdurchmesser geschehen. Man kann so die elektrische Leitfähigkeit des 2DEG mit dem Ionenstrahl in beliebige Bereiche "zerschneiden". Dieses Isolationsschreiben wendet man gemäß Fig. 8 bei senkrechtem Ionenstrahleinfall auf eine Heterostruktur an, indem man zwei Linien schreibt, die das 2DEG in drei Bereiche Gate 1 (36), Gate 2 (34) und den durch einen sehr schmalen Kanal 44 verbundenen Source-Drain-Bereich 46-48 teilen. Da die Struktur der Fig. 8 der der Fig. 3 entspricht, sind für die gleichen Teile die gleichen Bezugszeichen verwendet worden. Die Grundstruktur entspricht im übrigen vollständig der der Fig. 1. Man merkt, daß bei der Ausführungsform der Fig. 8 die zwei durch den Ionenstrahl gebildeten isolierenden Linien 30 und 32 so angeordnet sind, daß die jeweiligen Ecken 31. 33 einander gegenüberliegen, was eine sehr vorteilhafte Anordnung darstellt, da der Kanal eine ideale Gestalt aufweist und der kürzest mögliche Kanal entsteht.

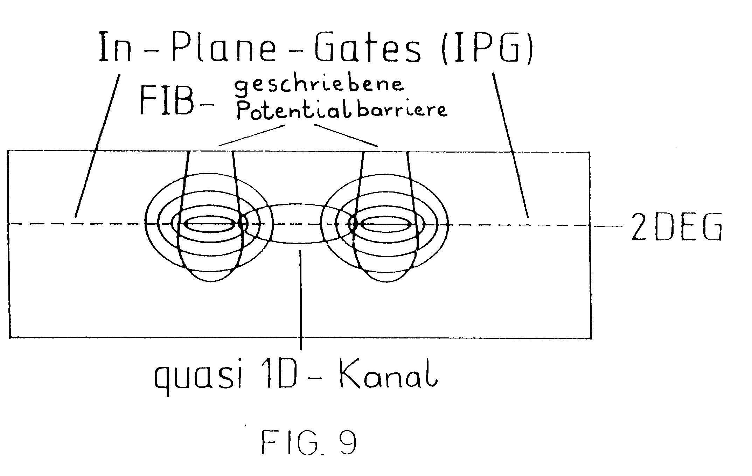

Zwischen Source und Drain bildet sich dabei eine Einengung aus, deren effektive elektrische Breite w kleiner ist als der kleinste Abstand w_{geo.} zwischen den FIB-Linien. Die punktierten Linien 30.1 und 32.1 stellen die Grenze zwischen der unzerstörten Kristallstruktur und der zerstörten Struktur dar und berücksichtigen, daß die Zerstörung durch den Ionenstrahl über die durch die fetten Striche kennzeichneten Linienbereiche 30, 32 hinausgeht. Indem die Bereiche des 2DEG rechts und links von diesem Kanal (Gate 1 und Gate 2) als elektrostatische Gates mit einer Gatespannung Vₐ relative zum Kanal (source-Anschluß) belegt werden, kann w von einigen µm bis auf Null durchgestimmt werden. Die Verteilung des elektrischen Feldes E in dieser Struktur zeigt Fig. 9. Deutlich ist zu sehen, daß E vorwiegend in der Ebene des 2DEG liegt und damit den Kanal effizient von beiden Seiten abschnüren kann. Die konzentrischen Ellipsen links und rechts vom quasi-1D-Kanal in der Mitte deuten die elektrische Feldverteilung an, die sich aufgrund der angelegten Gatespannung ausbildet. Durch die geringe Ausdehnung des 2DEG in der Kristallwachstumsrichtung (ca. 10 nm) sowie die lateralen Ecken der Gates tritt zusätzlich eine Feldüberhöhung (Spitzenwirkung) in Kanalnähe auf, die diesen Vorgang noch begünstigt. Das Besondere an dieser Struktur ist nicht nur die einfache Herstellung von quasi-eindimensional leitenden Kanälen, sondern auch die Methode, Gates aus derselben leitfähigen Struktur wie den Kanal, nämlich aus dem 2DEG, herzustellen. Damit hat das kontrollierende Element "Gate" die gleiche Struktur wie das kontrollierte Element "Kanal". Dieses wichtige Prinzip könnte mit einer Entwicklung verglichen werden, die am Ende der fünfziger Jahre in der Informatik gemacht wurde, als man erkannte, daß kontrollierende und kontrollierte Elemente (Programme bzw. Daten) am effektivsten nutzbar sind, wenn sie im Speicher gleichberechtigt koexistieren. Es ist zu erwarten, daß die erfindungsgemäße Strukturgleichheit der Gates und Kanäle, mit dem IPG-Transistor in der Hochintegration realisiert, einen vergleichbaren epochalen Entwicklungsschub in der Mikroelektronik auslösen wird, wie es damals in der Informatik geschah.

Besonders interessant ist es, die Gate-Kanal-Kapazität zu untersuchen. Für eine Kurzkanal-IPG-Struktur mit w_{geo} = 4.2µm ist eine einseitige Gate-Kanal-Kapazität C = 100 fF gemessen worden. Der effektive Gatebereich ist etwa 100 mal kürzer als die 350 µm-lange FIB-Linie, damit ist die effektive Kapazität C_{eff} ≈ 1 fF.

Die Kapazität kann man auch durch theoretische Überlegungen zumindest grob schätzen.

Die Ausgangselektronendichte auf der Heterostruktur ist n = 3 x 10¹¹cm⁻² = 3 x 10¹⁵m⁻². Bei w_{geo} = 4.2 µm dürfte der vom Gate beeinflußte Kanalbereich etwa 2x2 µm groß sein, das sich 4x10⁻¹²m². Multipliziert mit n ergibt das etwa 12000 Elektronen, die wir mit einer Thresholdspannung von Vₜₕ = -4V ausräumen können. Die Kapazität ist damit 12000 . e/4V ≈ 0.5 fF, was in überraschend guter Übereinstimmung mit dem oben gemessenen Wert ist.

Der Gatewiderstand beträgt bei Raumtemperatur etwa R_{g} = 1KΩ/_{□} . Multipliziert mit C_{eff} ergibt sich eine Zeitkonstante von R_{g} . C_{eff} = 1 ps, d.h. diese Struktur kann bei einer Frequenz von 1 THz betrieben werden. Bei tiefen Temperaturen fällt R_{g} noch einmal um etwa zwei Größenordnungen, so daß man mit ungefähr 100 THz rechnen kann.

Der Widerstand bzw. die Leitfähigkeit eines IPG-Kanals ist in Fig. 10 gegen die Gatespannung V_{g} dargestellt, wobei w_{geo}=2.8 µ beträgt. Die Fig. 10 entspricht im wesentlichen der Fig. 5, wurde jedoch mit einem etwas empfindlicheren Meßgerät bei einer Tempertur von 1.1 K aufgenommen, und zwar von einem FET mit Aufbau gemäß Fig. 1 und isolierenden Bereichen gemäß Fig. 8. Die Leitfähigkeit ist im wesentlichen proportional zu V_{g} - Vₜₕ, wobei Vₜₕ die Einsatzspannung von -4.1V ist, bei der der Kanal vollständig abgeschnürt (isolierend) ist. Bei tiefen Temperaturen wie in Fig. 10 sind dieser Geraden jedoch äquidistante Strukturen überlagert, die bei ganzzahligen Vielfachen der elementaren Leitfähigkeit 2e²/h auftreten. Diese Beobachtung ist ein Beleg dafür, daß ein beträchtlicher Teil der den Kanal passierenden Elektronen ballistisch ist, d.h. keine Streuung an Störstellen oder Phononen erfährt. Dies zeigt, daß die hohe Qualität der Ausgangsstruktur bei der FIB-Strukturierung im Kanalbereich erhalten wurde. Der Transport findet dabei durch m eindimensionale Subbänder im Kanal statt, wobei m in Fig. 10 zwischen 1 und 4 verändert werden kann. Um diese Strukturen, die durch ballistischen Transport in eindimensionalen Subbändern entstehen, für m≥2 besser aufzulösen, ist die Differenz zwischen der gemessenen Leitfähigkeit und einer theoretischen Geraden im unteren Teil der Fig. 10 mit einem vergrößerten Vertikalmaßstab aufgetragen. Die Kanallänge ist in der Größenordnung des Krümmungsradius des durch die Gates gebildeten Coulombpotentials, also einige µm. Daher ist verständlich, daß die Quantisierungsstufen nicht so scharf wie in Kurzkanalgeometrien aufgelöst werden.

diese ballistischen Effekte werden nur bei Temperaturen T≤10K und Source-Drain Spannungen V_{sd}≤kT beobachtet. Der IPG-Transistor ist aber auch im klassischen Grenzfall bei wesentlich höheren Temperaturen T und sogar Source-Drain-Spannungen V_{SD}>>kT funktionsfähig. Bild 11 zeigt Drainstrom-V_{SD} Transistorkennlinienscharen der FET der Fig. 8 für -1V≤V_{SD}≤1V und T=77K bei verschiedenen V_{g}, wobei w_{geo} hier 4.2µm ist. Der Kanal is "normal-on" (d.h. bei V_{g}=0 V leitend) und kann sowohl mit positivem V_{g} angereichert als auch mit negativem V_{g} verarmt werden. Bei V_{g}=-4V ist der Kanal praktisch isolierend. Die Kennlinienschar ist symmetrisch um den Nullpunkt, da |V_{SD}|≤|V_{g}| ist. Bei V_{g}= +5V beträgt der Kanalwiderstand 6kΩ, bei V_{g}= -4V liegt er oberhalb 10⁷Ω.

Die einzelnen Bilder sind wie folgt zu erläutern:

a) zeigt die I-V-Kennlinie zwischen Gate und Kanal, bei -5.6V≤V_{g}≤5.6V sind die Gates vom Kanal isoliert. b) zeigt IV-Kennlinien für verschiedene positive V_{g}, wobei der Mittelpunkt des Diagramms der Koordinatenursprung ist. Die Kurve mit den kleinsten absoluten Ordinatenwerten entspricht V_{g}=0V, die darüberliegenden entsprechen positiven V_{g} in jeweils 1V-Schritten (V_{g}=0V, die darüberliegenden entsprechen positiven V_{g} in jeweils 1V-Schritten (V_{g}=1,2,3,4,5V). In c) werden I-V-Kennlinien wie in b) gezeigt, jedoch für negative V_{g}. Die Kurve mit den größten absoluten Ordinatenwerten entspricht V_{g}=0V, die darunterliegenden V_{g}=-1,-2,-3,-4V).

Fig. 12 zeigt Kennlinienscharen derselben IPG-Struktur (d.h. die Struktur von Fig. 8, so wie sie für die Messungen gemäß Fig. 11 verändert wurde), bei Raumtemperatur und größeren Source-Drain Spannungen V_{SD} von bis zu 5 V, die vergleichbar mit den angelegten Gatespannungen sind. In b) und c) ist der Koordinatenursprung in der linken unteren Ecke des Diagramms. Die Doppellinien und leichten Schleifen sind Artefakte des Kennlinienschreibers. Mit diesen Ergebnissen ist der Beweis dafür geliefert, daß ein solcher Transistor einen weiteren treiben kann, was eine Grundvoraussetzung für die Anwendung in integrierten Schaltungen ist. Ein weiteres technologisches Detail sind die zwei Gates in Fig. 9, die bislang parallel geschaltet waren: Hierzu ist eine externe Kreuzverbindung zwischen Gate 1 und Gate 2 notwendig, die sich insbesondere in der Hochintegration störend bemerkbar macht. Das Problem kann elegant gelöst werden, indem z.B. Gate 1 mit der Source verbunden wird (durch teilweisen Wegfall der FIB-Linie zwischen dem Kanal und dem unteren Probenrand in Bild 1). Dadurch wird das elektrische Potential quer zum Kanal asymmetrisch. d.h. die Elektronen werden bei negativen Gatespannungen am verbleibenden Gate 2 zur isolierenden FIB-Linie am früheren Gate 1 gedrückt. Tatsächlich sind die Kennlinien in Fig. 11 und 12 bereits in dieser Konfiguration aufgenommen worden. Neben der Realisierung eines echten 3-Terminal Bauelements bietet diese Anordnung noch einen weiteren Vorteil: Die Kristallqualität und damit die Ladungsträgerdichte n und Beweglichkeit µ nimmt in Richtung auf die FIB-geschriebene Barriere graduell ab. Damit werden die Elektronen bei negativeren Gatespannungen mehr und mehr in Bereiche verlagert, in denen nicht nur n, sondern auch µ verringert ist. Diese Modulation der Beweglichkeit äußert sich direkt in einer Änderung der Leitfähigkeit des Kanals, die nicht durch Umladungsprozesse zustande kommt (Geschwindigkeitsmodulation). Damit ist der Response des IPG-Transistors schnell und es können hohe Arbeitsfrequenzen erreicht werden. Weiterhin bewirkt die Geometrie der IPG-Anordnung eine entscheidende Verringerung der internen Kapazitäten, während ein herkömmlicher FET eine Kapazität aus übereinanderliegenden Schichten (Gate und 2DEG) darstellt, besteht der IPG-Transistor aus nebeneinanderliegenden Schichten (Fig. 9), die eine um etwa eine Größenordnung geringere Gate-Kapazität als beim FET aufweisen.

Eine wesentliche Stärke des erfindungsgemäßen IPG-Prinzips liegt aber nicht nur in der Durchstimmbarkeit der Kanalleitfähigkeit und der Breitbandigkeit des Frequenzverhaltens, sondern auch in der Integrierbarkeit der Struktur. Die Fig. 6 und 7 haben bereits eine einfache Schaltung gezeigt, die direkt in ein FIB-Schreibmuster umgewandelt werden kann (Fig. 7). Der fokussierte Ionenstrahl kann in einem Arbeitsgang, d.h. ohne abzusetzen, IPG-Transistoren, Widerstände, Kapazitäten und Induktivitäten schreiben, die sofort nach dem Schreiben betriebsbereit sind. Es ist sogar möglich, die Eindringtiefe des Ionenstrahls mit der Ionen-Beschleunigungsspannung zu variieren und damit selektiv verschieden tief liegende 2DEG-Schichten lateral zu strukturieren, beispielsweise, um Kreuzverbindungen herzustellen. Die Schreibgeschwindigkeit des verwendeten JIBL-100A-Ionenstrahlschreibers beträgt maximal 0.3 m/s, so daß wir bereits mit dem zur Verfügung stehenden Laborgerät - ausgehend von 2 x 2 µm großen IPG-Transistoren - 10⁶ Transistoren in 10 s schreiben können!

Angesichts der etwa 500 Prozeßschritte bei der konventionellen IC-Produktion-gegenüber einem einzigen für integrierte IPG-Schaltungen- wird damit sogar das sequentielle Schreiben mit einem fokussierenden Ionenimplanter für die Fertigung attraktiv. Darüberhinaus können komplexe IPG-Schaltungen auch mit konventionellen, großflächigen Ionenimplantern mit Masken erzeugt werden. Die Möglichkeit, einen hochintegrierten Chip in Mikrosekunden herzustellen, läßt die Relevanz der Ionenimplantation für die Mikrostrukturfertigung der Zukunft erahnen.

Die Fig. 13A zeigt eine mögliche Konfiguration der isolierenden Linien 30, 32, welche die Gate-Bereiche bestimmen. Bei einem langen Kanal 44 und großer Source-Drain Spannung entsteht ein Spannungsabfall entlang des Kanals (Richtung x), die in Fig. 13B gezeigt ist. Wenn man nun den Wert (V_{g}-V) in Funktion x betrachtet (Fig. 13C), so wird ersichtlich, daß das E-Feld am Drain-Ende des Kanals stärker ist als am Source-Ende, so daß die Stromverteilung im Kanal nicht gleichmäßig ist, sondern ein eingeschnürtes "pinch-off"-Verhalten aufweist wie in Fig. 13D dargestellt. Dies ist unerwünscht, da es zu lokaler Überhitzung und zu vorzeitigem Versagen des Bauteils bzw. der Schaltung führt. Um hier Abhilfe zu schaffen, wird die Anordnung gemäß Fig. 14 bevorzugt. Hier wird das "pinch-off"-Verhalten durch die Verwendung eines in Richtung des Spannungsgradienten divergierenden, etwa trapezförmigen Kanals 44 kontrolliert, d.h. der Kanal reißt nicht wie oben beschrieben an seinem Ende ab, sondern wird gleichmäßig über die gesamte Länge hinweg schmäler. Hiermit werden "heiße" Bereiche am Kanalende bei stark negativen Gatespannungen nahe der Einsatzspannung Vₜₕ vermieden. Die Trapezform (lineare Verarbeitung) bringt nur eine grobe Vergleichsmessung der Stromdichte im Kanal zustande und andere Formen (Hyperbel 1/x, Exponential e^{x}, usw) bieten noch günstigere Wirkungen an. Alle Varianten führen zu einer in Richtung des Spannungsgradienten divergierenden Gestalt. Dieses Modell gilt eigentlich nur für eine bestimmte Arbeitsspannung Vₒ. Bei Abweichungen von Vₒ ist es weniger ideal, aber immer noch viel besser als ohne Verbreiterung über die Länge x.

Fig. 14 zeigt daher eine alternative Gestaltung der Gate-Bereiche mit in Richtung des Spannungsgradienten divergierenden Gestalt, die in der Praxis einen bedeutenden Vorteil aufweist gegenüber einer rechteckigen Gestalt. Das skizzierte "Pinch-off"-Verhalten-Modelling durch trapezförmigen (oder komplizierten) Kanal funktioniert auch bei einseitigem Gate (3-Terminal-Device).

Fig. 15A zeigt ein Beispiel für ein ODER-Gatter, das nach der Erfindung realisierbar ist, beispielsweise als Teil einer hochintegrierten Schaltung. Das dazu passende Ersatzschaltbild ist in Fig. 15B wiedergegeben. Die Linienführung der isolierenden Bereiche ist so gewählt, daß ein Kanal 100 zwischen zwei Gate-Bereichen 101, 102 gebildet wird. Unterhalb des Kanals 100 befindet sich ein Anschlußbereich 104, welcher an einer positiven Klemme einer Spannungsquelle angeschlossen wird. Oberhalb der beiden Gate-Bereiche 101, 102 befindet sich ein mäanderförmiger Widerstandspfad 106, welcher von einem Anfang 108, der der Mündung des Kanals gegenübersteht, bis zu einem Bereich 110 führt, der beim Betrieb an einer negativen Klemme der Spannungsquelle angeschlossen wird. Der Bereich 112 zwischen dem Kanal 100 und dem Eingang 108 ist an zwei Stellen 114, 116 kontaktiert und diese gleichwertigen Kontakte, welche zwei alternative gleichwertige Ausgangsklemmen des ODER-Gatters darstellen, führen stets die gleiche Spannung. Auf entsprechende Weise sind die Bereiche 101, 102, 104 und 110 mit jeweiligen Kontakten 122, 124, 118 bzw. 120 versehen. Der Darstellung halber sind die Seitenkanten des quadratischen Chips in der Höhe der Gate-Bereiche 101, 102 sowie in der Höhe des Ausgangsbereichs 112 nicht eingezeichnet.

Um die Zuordnung der Kontakte zu dem Ersatzschaltbild gemäß Fig. 15B zu erleichtern, sind die Anschlußquellen im Ersatzschaltbild mit den gleichen Bezugszeichen versehen wie in Fig. 15A. Alle schwarzen Bereiche mit Ausnahme der Seitenkanten des Chips sind durch Isolierschreiben hergestellt worden. Wenn das ODER-Gatter nur ein Bauteil auf einem Chip darstellt, so kann es beispielsweise dadurch hergestellt werden, daß die quadratische Umrahmung an allen Seiten geschlossen ist, außer an den Stellen, wo eine Verbindung zu anderen Bauteilen erfolgt. Aus diesem Grunde sind an den Seiten des Bauteils in der Höhe der zwei Gate-Bereiche 101, 102 und des Ausgangsbereiches 112 keine isolierenden Bereiche gezeigt. Selbstverständlich ist es nicht notwendig, bei Verwendung des Bauteils auf einem Chip alle diese Bereiche einzeln zu kontaktieren, da im Regelfall die Spannungsversorgung zu diesen Bereichen bzw. die Spannungsabnahme von diesen Bereichen über Verbindungen zu anderen Bauteilen erfolgt, d.h. über die zweidimensionale Ladungsträgerschicht.

Liegt an den Bereichen 101, 102 keine Spannung an, so ist der Eingangsbereich 104 mit dem Ausgangsbereich 110 über den den Widerstand bildenden Bereich 106 verbunden, so daß der Kanal 100 und der Widerstandsbereich 106 einen Spannungsverteiler bilden und eine entsprechende Spannung an den Kontakten 114, 116 abgegriffen werden kann. Da der Widerstand des Kanals im offenen Zustand sehr gering ist, entspricht in der Praxis die Spannung im Drainbereich 112 der Sourcespannung. Wird dagegen eine Steuerspannung an dem Bereich 101 und/oder an dem Bereich 102 angelegt, so dient diese Steuerspannung dazu, den Kanalbereich 100 vollständig zu sperren, so daß die Spannung im Bereich 112 der im Bereich 110 herrschenden Spannung entspricht. D.h. durch das Anlegen einer Spannung an einem oder mehreren der beiden Gate-Bereiche hat sich die Ausgangsspannung von hoch auf niedrig geändert, so daß die Funktion eines ODER-Gatters vorliegt. In Fig. 15B ist der dem Bereich 106 entsprechende Widerstand ebenfalls mit dem Bezugszeichen 106 gekennzeichnet und der Kanal 100 mit einem fetten senkrechten Strich eingezeichnet, der zum leichten Verständnis ebenfalls das Bezugszeichen 100 trägt. Man kann diesen fetten Strich 100 bzw. den Kanal 100 sich so vorstellen, daß er durch zwei FET's gebildet ist, deren Gate-Elektroden aneinander angeschlossen sind.

Fig. 16A zeigt ein UND-Gatter 130, wobei die Fig. 16B das Ersatzschaltbild für dieses UND-Gatter darstellt. Man merkt, daß die Ausbildung des UND-Gatters dem des ODER-Gatters ähnlich ist, weshalb für entsprechende Bereiche die gleichen Bezugszeichen verwendet werden, jedoch mit dem Zusatz .1. Im Unterschied zu dem ODER-Gatter der Fig. 15A sind hier aber zwei Kanalbereiche 100.1 und 100.2 vorgesehen, welche jeweils zwischen einem der Elektrodenbereiche 101, 102 und einer mittleren n-förmigen isolierenden Linie 132 gebildet sind. Wird hier eine Steuerspannung an einen der Kontakte 122.1 bzw. 124.1 angelegt, so wird nur der jeweils zugeordnete Kanal 100.1, 100.2 gesperrt, während der andere Kanal noch leitend bleibt und das Bauteil als Spannungsteiler arbeitet, so daß eine entsprechende Spannung an einem oder mehreren der Kontakte 114.1, 116.1 abgegriffen werden kann. Werden dagegen Steuersignale an beide Gate-Bereiche 100.1, 102.1 angelegt, so werden beide Kanäle 100.1, 100.2 verarmt und die Spannung im Bereich 112.1 entspricht der im Bereich 110.1. Aus dieser Beschreibung sieht man, daß das Bauteil als UND-Gatter funktioniert. Im Ersatzschaltbild gemäß Fig. 16B kann man sich die beiden Kanäle 100.1, 100.2 so vorstellen, als ob sie durch zwei FET's gebildet sind, die Source an Source und Drain an Drain miteinander verbunden sind.

Wie im Zusammenhang mit Fig. 15A und 16A erwähnt, funktionieren die Bauteile im leitenden Zustand als Spannungsteiler. Durch geeignete Wahl der Widerstands 106 ist dieser weitaus größer als der des Kanals 100 bzw. als der der Kanäle 100.1, 100.2. Hierdurch entspricht die Spannung im Bereich 112 bzw. im Bereich 112.1 der positiven Versorgungsspannung im Bereich 104 bzw. 104.1, so daß eine ganze Reihe von solchen Gattern in einem Chip verkettet werden können, ohne daß es zu ausgeprägten Spannungsverlusten kommt.

Statt den Widerstand 106 bzw. 106.1 durch einen mäanderförmigen Weg zu bilden, was Induktivität mit sich bringt, kann man mittels des Ionenstrahls eine Reihe von Steinen, d.h. isolierende Bereiche in einem leitenden Bereich plazieren wie beispielsweise bei 130 in Fig. 15A, wodurch der Widerstand dieses Bereiches ebenfalls erhöht wird. In der Praxis sind viel mehr "Steine" 130 erforderlich und sie werden in einem Punktraster entsprechend den Fig. 17A und 17B anstatt der mäanderförmigen Wege auf dem Chip plaziert.

Mit dieser Beschreibung ist klargestellt worden, daß man auch Logikbauteile ohne weiteres mittels der Erfindung produzieren kann. Selbstverständlich kann man auch jede andere bekannte Art von Gattern ebenfalls durch geeignete Linienführung der isolierenden Bereiche ausbilden und auch solche Gatter miteinander auf einem Chip kombinieren, um eine integrierte oder hochintegrierte Schaltung zu erzeugen, welche selbstverständlich auch mit anderen aktiven und passiven Schaltungselementen ausgestattet werden kann, die ebenfalls mittels des erfindungsgemäßen Verfahrens hergestellt werden.

Wie bereits erwähnt, ist es nicht unbedingt notwendig, die isolierenden Bereiche mit einem scharf fokussierten Ionenstrahl zu bilden, sondern man kann durch Photolithographie eine Maske bilden und dann eine Grundstruktur gemäß Fig. 1 mittels eines ausgedehnten Ionenstrahls durch die Maske hindurch belichten, um eine entsprechende linienweise Zerstörung zu erreichen. Dabei kann die Maske entweder eine getrennte dünne Metallfolie sein, die auf die Oberfläche des Chips aufgelegt wird, oder sie kann durch Photolithographie auf der Oberfläche des Chips selbst erzeugt werden. Die Öffnungen in der Maske entsprechen, was ihre Lage und Auslegung betrifft, den erwünschten insulierenden Linien auf dem Chip.

Überall, wo der FIB-Strahl nicht direkt den Kanal eingrenzt (berührt), kann ein wesentlich breiterer FIB-Strich (Linie) geschrieben werden, um das elektrische Durchbruchverhalten bei großen Gatespannungen zu verbessern und die Gesamtkapazität des (der) Gates relativ zum Source und Drain zu verringern.

## Patentansprüche

1. Verfahren zur Erzeugung einer aktiven Halbleiterstruktur mittels einer Ausgangshalbleiterstruktur, welche parallel zur Oberfläche (10) eine 2D-Ladungsträgerschicht aufweist, wobei die Ausgangsstruktur behandelt wird, um laterale linienförmige Potentialbarrieren (30, 32) in der 2D-Ladungsträgerschicht aufzubauen und hierdurch diese in Bereiche aufzuteilen, und wobei Kontakte zu diesen Bereichen der 2D-Ladungsträgerschicht vorgesehen werden, dadurch gekennzeichnet, daß zur Erzeugung eines Feldeffekttransistors die Aufteilung in Bereiche so erfolgt, daß wenigstens ein durch eine erste linienförmige Potentialbarriere seitlich geschlossener Gate-Bereich (34) der 2D-Ladungsträgerschicht sowie Source- und Drain-Bereiche (46, 48) der 2D-Ladungsträgerschicht entstehen, wobei der Source-Bereich (46) und der Drain-Bereich (48) voneinander durch eine zweite linienförmige Potentialbarriere (32) getrennt sind, jedoch miteinander über einen Kanalbereich (44) der 2D-Ladungsträgerschicht verbunden sind, welcher sich zwischen dem seitlich geschlossenen Gate-Bereich (34) und der zweiten linienförmigen Potentialbarriere (32) erstreckt, wobei der seitlich geschlossene Gate-Bereich von dem Kanalbereich durch die erste linienförmige Potentialbarriere getrennt ist, und Kontakte zu der 2D-Ladungsträgerschicht des seitlich geschlossenen Gate-Bereiches sowie zu der 2D-Ladungsträgerschicht in den Source- und Drain-Bereichen (46, 48) hergestellt werden.

2. Verfahren nach Anspruch 1, dadurch gekennzeichnet, daß der seitlich geschlossene Gate-Bereich der 2D-Ladungsträgerschicht ein rechteckiger Bereich der Ausgangshalbleiterstruktur ist, dessen dem mittleren Bereich der Ausgangshalbleiterstruktur zugewandte Ecke der zweiten linienförmigen Potentialbarriere (32) gegenüberliegend angeordnet wird.

3. Verfahren nach Anspruch 2, dadurch gekennzeichnet, daß das der Ecke gegenüberliegende Ende der zweiten linienförmigen Potentialbarriere (32), die ggf. als abgewinkelte Linie ausgebildet sein kann, mit der Ecke den Kanal (44) begrenzt.

4. Verfahren nach Anspruch 2, dadurch gekennzeichnet, daß die zweite linienförmige Potentialbarriere (32) an ihren beiden Enden sich bis zu der seitlichen Begrenzung der Ausgangshalbleiterstruktur erstreckt und einen zweiten, seitlich geschlossenen Bereich der 2D-Ladungsträgerschicht und daher ein zweites Gate (36) bildet, wobei ggf. eine leitende externe Verbindung zwischen den zwei Gates hergestellt wird.

5. Verfahren nach einem der vorhergehenden Ansprüche, dadurch gekennzeichnet, daß durch die Ausbildung von linienförmigen lateralen Potentialbarrieren in der 2D Ladungsträgerschicht die Ausgangsstruktur in eine integrierte oder hochintegrierte Schaltung umgewandelt wird, wobei zusätzlich zu der Erzeugung von aktiven Halbleiterstrukturen auch passive Schaltungselemente bspw. in Form von Widerständen und Induktivitäten durch entsprechende Linienführung erzeugt werden.

6. Verfahren nach Anspruch 5, dadurch gekennzeichnet, daß die Halbleiterstruktur wenigstens zwei parallel zu der Oberfläche (10) liegende und voneinander in Richtung senkrecht zu der Oberfläche (10) einen Abstand aufweisende 2D-Ladungsträgerschichten hat, daß die linienförmigen Potentialbarrieren durch linienweise Zerstörung der Ausgangshalbleiterstruktur erzeugt werden, und daß die linienweise Zerstörung so vorgenommen wird, daß elektrische Verbindungen zwischen den 2D-Ladungsträgerschichten entstehen.

7. Verfahren nach einem der vorhergehenden Ansprüche, dadurch gekennzeichnet, daß man als Ausgangshalbleiterstruktur III-V Verbindungshalbleiter wählt.

8. Verfahren nach Anspruch 7, dadurch gekennzeichnet, daß man als Verbindungshalbleiter AlₓGa₁₋ₓAs nimmt, wobei die 2D-Ladungsträgerschicht ein 2D-Elektronengas ist.

9. Verfahren nach Anspruch 8, dadurch gekennzeichnet, daß das 2D-Elektronengas sich im Grenzbereich zwischen einer undotierten Al_{0,3}Ga_{0,7}As-Schicht (20) mit einer Dicke kleiner als 50 nm (500 Å), vorzugsweise etwa 20 nm (200 Å) und einer undotierten dickeren Schicht (18) aus GaAs befindet, wobei die Elektronen aus einer auf der der GaAs-Schicht abgewandten Seite der Al_{0,3}Ga_{0,7}As-Schicht angeordneten dotierten Schicht (22) stammen, beispielsweise einer Schicht aus Al_{0,3}Ga_{0,7}As von etwa 50 nm (500 Å) Dicke, die mit Si-Atomen in einer Konzentration von etwa 10¹⁸cm⁻³ n-dotiert ist.

10. Verfahren nach einem der vorhergehenden Ansprüche, dadurch gekennzeichnet, daß die Oberfläche (10) der Ausgangshalbleiterstruktur in Miller'schen Indizes eine [100]-Fläche ist.

11. Verfahren nach einem der vorhergehenden Ansprüche, dadurch gekennzeichnet, daß die linienförmigen Potentialbarrieren durch linienweise Zerstörung der Ausgangshalbleiterstruktur mittels eines fokussierten computergesteuerten Ionenstrahls erzeugt wird.

12. Verfahren nach einem der vorhergehenden Ansprüche, dadurch gekennzeichnet, daß die lateralen linienförmigen Potentialbarrieren in der 2D-Ladungsträgerschicht durch Ionenimplantation erzeugt werden, beispielsweise um eine P-Dotierung der Ausgangshalbleiterstruktur zu erreichen, bei der die Ladungsträger der 2D-Ladungsträgerschicht Elektronen sind.

13. Verfahren nach einem der vorhergehenden Ansprüche, dadurch gekennzeichnet, daß die Erzeugung der lateralen linienförmigen Potentialbarrieren in der 2D-Ladungsträgerschicht durch linienweise Zerstörung der Leitfähigkeit der Ausgangsstruktur durch Beschuß der Ausgangshalbleiterstruktur mit Ionen durch eine Maske hindurch erfolgt, wobei diese Maske entweder auf der Oberfläche (10) der Ausgangshalbleiterstruktur durch das an sich bekannte photolithographische Verfahren erzeugt und nach der Ionenimplantation wieder entfernt wird oder in Form einer von der Ausgangshalbleiterstruktur getrennten Maske auf die Oberfläche (10) der Ausgangshalbleiterstruktur gelegt wird, wobei in beiden Fällen die Maske vorzugsweise eine metallische Maske ist.

14. Verfahren nach einem der Ansprüche 11 oder 13, dadurch gekennzeichnet, daß nach dem Erzeugen der Bereiche mit den lateralen linienförmigen Potentialbarrieren die Ausgangshalbleiterstruktur einer Wärmebehandlung ausgesetzt wird, die zu einer teilweisen Ausheilung der Zerstörung und zu einer schärferen Definition der so entstandenen isolierenden Linien führt.

15. Verfahren nach Anspruch 5, dadurch gekennzeichnet, daß für die externen Anschlüsse an der Schaltung in ausgewählten Elektrodenbereichen ein Kontakt zu dem jeweiligen Bereich der 2D-Ladungsträgerschicht hergestellt wird.

16. Verfahren nach Anspruch 15, dadurch gekennzeichnet, daß die aktiven Bauelemente logische Gatter und die passiven Bauelemente Widerstände und/oder Induktivitäten einschließen.

17. Verfahren nach einem der Ansprüche 15 oder 16, dadurch gekennzeichnet, daß die Widerstände durch längliche Bereiche der 2D-Ladungsträgerschicht gebildet sind.

18. Verfahren nach einem der Ansprüche 15 bis 17, dadurch gekennzeichnet, daß die Induktivitäten durch mäanderförmige Bereiche der 2D-Ladungsträgerschicht gebildet sind.

19. Feldeffekttransistor, mit Source-, Drain- und Gate-Elektroden (54, 56, 50, 52), bestehend aus einer Halbleiterstruktur mit einer parallel zu ihrer Oberfläche (10) verlaufenden 2D-Ladungsträgerschicht, wobei die Halbleiterstruktur durch laterale linienförmige Potentialbarrieren (30, 32) in der 2D-Ladungsträgerschicht in Source-, Drain- und Gate-Elektrodenbereiche (46, 48, 34, 36) der 2D-Ladungsträgerschicht sowie in einen dem Gate-Elektrodenbereich benachbart liegenden, leitfähigen Kanalbereich (44) unterteilt ist, wobei die Aufteilung in Bereiche so erfolgt, daß wenigstens ein durch eine erste linienförmige Potentialbarriere seitlich geschlossener, den Gate-Elektrodenbereich bildender Bereich (34) der 2D-Ladungsträgerschicht sowie erste und zweite weitere, den Source- bzw. den Drain-Elektrodenbereich bildende Bereiche (46, 48) der 2D-Ladungsträgerschicht vorhanden sind, wobei der Source-Elektrodenbereich (46) und der Drain-Elektrodenbereich (48) voneinander durch eine zweite linienförmige Potentialbarriere getrennt sind, jedoch miteinander über den Kanalbereich (44) der 2D-Ladungsträgerschicht verbunden sind, der sich zwischen dem seitlich geschlossenen Gate-Elektroden-Bereich (34) und der zweiten linienförmigen Potentialbarriere (32) erstreckt, wobei der seitlich geschlossene Gate-Elektrodenbereich von dem Kanalbereich durch die erste linienförmige Potentialbarriere getrennt ist, und daß die Kontaktierung der einzelnen Source-, Drain- und Gate-Elektrodenbereiche durch jeweilige Kontakte (54, 56, 50, 52) zu der 2D-Ladungsträgerschicht in diesen Bereichen erfolgt.

20. Feldeffekttransistor nach Anspruch 19, dadurch gekennzeichnet, daß der Kanalbereich (44) eine maximale Breite von etwa 5 µm aufweist.

21. Feldeffekttransistor nach einem der vorhergehenden Ansprüche 19 bis 20, dadurch gekennzeichnet, daß der Kanalbereich (44) zwischen einer Seite oder Ecke des Gate-Elektrodenbereiches (34) und der diesem gegenüberliegenden zweiten linienförmigen Potentialbarriere (32) gebildet ist.

22. Feldeffekttransistor nach Anspruch 21, dadurch gekennzeichnet, daß der Kanalbereich (44) durch die seitliche Begrenzung des Gate-Elektrodenbereiches (34) und das Ende der zweiten linienförmigen Potentialbarriere (32), die ggf. als abgewinkelte Linie ausgebildet sein kann, gebildet ist.

23. Feldeffekttransistor nach einem der vorhergehenden Ansprüche 19 bis 22, dadurch gekennzeichnet, daß die linienförmigen Potentialbarrieren aus isolierendem Material sind, daß die zweite linienförmige Potentialbarriere einen zweiten seitlich geschlossenen Gate-Elektrodenbereich bildet, daß der Kanalbereich (44) zwischen die zwei getrennten, durch isolierendes Material (30, 32) eingeschlossenen Gate-Elektrodenbereichen (34, 36) gebildet ist, und daß ggf. eine leitende externe Verbindung zwischen diesen beiden Gate-Elektroden vorgesehen ist.

24. Feldeffekttransistor nach einem der Ansprüche 19 bis 21, dadurch gekennzeichnet, daß der Gate-Elektrodenbereich (34) durch eine linienförmige Potentialbarriere (32) aus isolierendem Material abgegrenzt ist, die sich an ihren beiden Enden bis zu der seitlichen Begrenzung der Halbleiterstruktur erstreckt, und daß die Source- und Drain-Elektrodenbereiche (46, 48) auf entgegengesetzten Seiten der linienförmigen Potentialbarriere (32) aus isolierendem Material gebildet sind, wobei sich diese linienförmige Potentialbarriere (32) an ihrem einen Ende ebenfalls bis zu der seitlichen Begrenzung der Halbleiterstruktur erstreckt.

25. Feldeffekttransistor nach Anspruch 19, dadurch gekennzeichnet, daß zwei Gateelektrodenbereiche (34, 36) vorgesehen sind, wovon der eine an den Sourcebereich (46) angeschlossen sein kann, wobei die beiden Gateelektrodenbereiche (34, 36) durch jeweilige laterale linienförmige Potentialbarrieren in der 2D-Ladungsträgerschicht abgegrenzt sind, wovon jede sich um wenigstens eine Ecke erstreckt und der die Source-Elektrodenbereiche und die Drain-Elektrodenbereiche verbindende Kanalbereich (44) zwischen einander gegenüberliegenden Ecken (31, 33) der jeweiligen linienförmigen Potentialbarrieren (30, 32) gebildet ist.

26. Feldeffekttransistor nach Anspruch 19, dadurch gekennzeichnet, daß zwei Gateelektrodenbereiche (34, 36) vorgesehen sind, deren benachbarte, den sich zwischen der Source-Elektrodenbereich (46) und dem Drain-Elektrodenbereich (48) erstreckenden Kanalbereich (44) bildende einander gegenüberliegende Seiten in Richtung des Spannungsgradienten voneinander divergieren.

27. Feldeffekttransistor nach einem der vorhergehenden Ansprüche 19 bis 26, dadurch gekennzeichnet, daß die Halbleiterstruktur aus einem III-V-Verbindungshalbleiter besteht.

28. Feldeffekttransistor nach Anspruch 27, dadurch gekennzeichnet, daß der Verbindungshalbleiter AlₓGa₁₋ₓAs ist, wobei die 2D-Ladungsträgerschicht ein 2D-Elektronengas ist.

29. Feldeffekttransistor nach Anspruch 28, dadurch gekennzeichnet, daß das 2D-Elektronengas sich im Grenzbereich zwischen einer undotierten Al_{0,3}Ga_{0,7}As-Schicht (20) mit einer Dicke kleiner als 50 nm (500 Å), vorzugsweise etwa 20 nm (200 Å) und einer undotierten dickeren Schicht (18) aus GaAs befindet, wobei die Elektronen aus einer auf der der GaAs-Schicht abgewandten Seite der Al_{0,3}Ga_{0,7}As-Schicht angeordneten dotierten Schicht (22) stammen, beispielsweise einer Schicht aus Al_{0,3}Ga_{0,7}As von etwa 50 nm (500 Å) Dicke, die mit Si-Atomen in einer Konzentration von etwa 10¹⁸cm⁻³ n-dotiert ist.

30. Feldeffekttransistor nach einem der vorhergehenden Ansprüche 19 bis 29, dadurch gekennzeichnet, daß die Oberfläche der Halbleiterstruktur in Miller'schen Indizes eine [100]-Fläche ist.

31. Integrierte bzw. hochintegrierte Schaltung bestehend aus mehreren Feldeffekttransistoren nach Anspruch 19, dadurch gekennzeichnet, daß die laterale Potentialbarriere in der 2D-Ladungsträgerschicht sowohl aktive Bauelemente, wie Feldeffekttransistor, als auch passive Bauelemente, wie Widerstände oder Induktoren, durch Elektroden- und Kanalbereichen definieren, wobei aneinander angeschlossene Elektrodenbereiche benachbarter Bauelemente über die sich dazwischen befindliche 2D-Ladungsträgerschicht miteinander in leitfähiger Verbindung stehen und die Leitfähigkeit der Kanalbereiche der aktiven Bauelemente durch die Anbringung von geeigneten Steuerspannungen an die benachbarten Gate-Elektrodenbereiche veränderbar ist, und daß man für die externen Anschlüsse an der Schaltung in ausgewählten Elektrodenbereichen einen Kontakt zu der 2D-Ladungsträgerschicht herstellt.

## Claims

1. A method of generating an active semiconductor structure by means of a semiconductor starting structure which has a 2D charge carrier layer parallel to the surface (10), with the starting structure being treated to build up lateral, line-like, potential barriers (30, 32) in the 2D-charge carrier layer and hereby to divide this up into regions, and wherein contacts to these regions of the 2D-charge carrier layer are provided, characterized in that, in order to produce a field effect transistor, the dividing up into regions takes place in such a way that at least one gate region (34) of the 2D charge carrier layer, which is closed laterally by a first, line-like, potential barrier and also source and drain regions (46, 48) of the 2D-charge carrier layer arise, with the source region (46) and the drain region (48) being separated from one another by a second, line-like potential barrier (32), but are connected to one another via a channel region (44) of the 2D-charge carrier layer, which extends between the laterally closed gate region (34) and the second, line-like, potential barrier, wherein the laterally closed gate region is separated from the channel region by the first, line-like, potential barrier, and wherein contacts are produced to the 2D-charge carrier layer of the laterally closed gate region and also to the 2D-charge carrier layer in the source and drain regions (46, 48).

2. Method in accordance with claim 1, characterized in that the laterally closed gate region of the 2D-charge carrier layer is a rectangular region of the region of the semiconductor starting structure, with the corner of the rectangular region adjacent the central area of the semiconductor starting structure being arranged opposite to the second, line-like, potential barrier (32).

3. Method in accordance with claim 2, characterized in that the end of the second, line-like, potential barrier (32) opposite to the corner, which can, if necessary, be formed as an angled line, bounds the channel (44) together with the corner.

4. Method in accordance with claim 2, characterized in that the second, line-like, potential barrier (32) extends at its two ends up to the lateral boundary of the semiconductor starting structure and forms a second, laterally closed region of the 2D-charge carrier layer and thus a second gate (36); with a conductive external connection optionally being produced between the two gates.

5. Method in accordance with one of the preceding claims, characterized in that, through the formation of line-like, lateral potential barriers in the 2D-charge carrier layer, the starting structure is converted into an integrated or highly integrated circuit, with passive circuit elements, for example in the form of resistors and inductors being generated, in addition to the generation of active semiconductor structures, by corresponding line guidance.

6. Method in accordance with claim 5, characterized in that the semiconductor structure has at least two 2D-charge carrier layers which lie parallel to the surface (10) and are spaced apart from one another in the direction perpendicular to the surface (10); in that the line-like, potential barriers are produced by line-wise destruction of the semiconductor starting structure; and in that the line-wise destruction is so effected that electrical connections arise between the 2D-charge carrier layers.

7. Method in accordance with one of the preceding claims, characterized in that one selects III-V compositional semiconductors as a semiconductor starting structure.

8. Method in accordance with claim 7, characterized in that one takes AlₓGa₁₋ₓAs as the compositional semiconductor, with the 2D-charge carrier layer being a 2D electron gas.

9. Method in accordance with claim 8, characterized in that the 2D electron gas is located in the boundary region between an undoped Al_{0,3}Ga_{0,7}As layer (20) with a thickness smaller than 50 nm (500 A), preferably approximately 20 nm (200 Å) and an undoped thicker layer (18) of GaAs, with the electrons originating from a doped layer (22) arranged at a side of Al_{0,3}Ga_{0,7}As layer remote from the GaAs layer and consisting for example of a layer of Al_{0,3}Ga_{0,7}As of approximately 50 nm (500 Å) thickness which is n-doped with Si-atoms at a concentration of approximately 10¹⁸ cm⁻³.

10. Method in accordance with one of the preceding claims, characterized in that the surface (10) of the semiconductor starting structure is a [100] surface in Miller indices.

11. Method in accordance with one of the preceding claims, characterized in that the line-like, potential barriers are generated by the line-wise destruction of the semiconductor starting structure by means of a focussed, computer steered, ion beam.

12. Method in accordance with one of the preceding claims, characterized in that the lateral, line-like, potential barriers in the 2D-charge carrier layer are generated by ion implantation, for example by a p-doping of the semiconductor starting structure in which the charge carriers of the 2D-charge carrier layer are electrons.

13. Method in accordance with one of the preceding claims, characterized in that the generation of the lateral, line-like, potential barriers in the 2D charge carrier layer takes place by linear destruction of the conductivity of the starting structure by bombardment of the semiconductor starting structure with ions through a mask, with this mask either being generated on the surface (10) of the starting structure by the photolithographic process which is known per se, and being removed again after ion implantation, or being laid in the form of a mask separate from the semiconductor starting structure onto the surface (10) of the semiconductor starting structure, with the mask preferably being a metallic mask in both cases.

14. Method in accordance with one of the claims 11 or 13, characterized in that, after the production of the regions with lateral, line-like, potential barriers, the semiconductor starting structure is subjected to a heat treatment which leads to a partial healing of the destruction and to a sharper definition of the so arising insulating lines.

15. Method in accordance with claim 5, characterized in that, for the external connections to the circuit, a contact is produced in selected electrode regions to the respective region of the 2D-charge carrier layer.

16. Method in accordance with claim 15, characterized in that the active components include logic gates, and the passive components include resistors and/or inductors.

17. Method in accordance with one of the claims 15 or 16, characterized in that the resistors are formed by elongate regions of the 2D-charge carrier layer.

18. Method in accordance with one of the claims 15 to 17, characterized in that the inductors are formed by meandering regions of the 2D-charge carrier layer.

19. Field effect transistor with source, drain and gate electrodes (54, 56, 50, 52), comprising a semiconductor structure with a 2D-charge carrier layer extending parallel to its surface (10), with the semiconductor structure being subdivided into source, drain and gate electrode regions (46, 48, 34, 36) of the 2D-charge carrier layer and also into a conductive channel region (44) which lies adjacent to the gate electrode region, wherein the dividing-up into regions takes place in such a way that at least one region (34) of the 2D-charge carrier layer, which is laterally closed by a first, line-like, potential barrier, and also first and second further regions (46, 48) of the 2D-charge carrier layer forming the source and drain electrode regions are present, with the source electrode region (46) and the drain electrode region (48) being separated from one another by a second, line-like, potential barrier, but connected to one another via the channel region (44) of the 2D-charge carrier layer, which extends between the laterally closed gate electrode region (34) and the second, line-like, potential barrier (32), with the laterally closed gate electrode region being separated from the channel region by the first, line-like, potential barrier; and in that the contacting of the individual source, drain and gate regions takes place by respective contacts (54, 56, 50, 52) to the 2D charge carrier layer in these regions.

20. Field effect transistor in accordance with claim 19, characterized in that the channel region (44) has a maximum width of approximately 5 µm.

21. Field effect transistor in accordance with one of the preceding claims 19 to 20, characterized in that the channel region (44) is formed between a side or corner of the gate electrode region (34) and the second, line-like, potential barrier (32) which lies opposite thereto.

22. Field effect transistor in accordance with claim 21, characterized in that the channel region (44) is formed by the lateral boundary of the gate electrode region (34) and the end of the second, line-like, potential barrier (32), which can, if necessary, be formed as an angled line.

23. Field effect transistor in accordance with one of the preceding claims 19 to 22, characterized in that the line-like, potential barriers are of insulating material; in that the second, line-like, potential barrier forms a second, laterally closed gate electrode region; in that the channel region (44) is formed between the two separated gate electrode regions (34, 36) enclosed by insulating material (30, 32); and in that, if required, a conductive external connection is provided between these two gate electrodes.

24. Field effect transistor in accordance with one of the claims 19 to 22, characterized in that the gate electrode region (34) is bounded by a line-like, potential barrier (32) of insulating material which extends at its two ends up to the lateral boundary of the semiconductor structure; and in that the source and drain electrode regions (46, 48) are formed on opposite sides of the line-like, potential barrier (32) of insulating material, with this line-like, potential barrier (32) likewise extending at its one end up to the lateral boundary of the semiconductor structure.

25. Field effect transistor in accordance with claim 19, characterized in that two gate electrode regions (34, 36) are provided of which the one can be connected to the source region (46), with the two gate electrode regions (34, 36) being bounded by respective lateral, line-like, potential barriers in the 2D-charge carrier layer, of which each extends around at least one corner and wherein the channel region (44) which connects the source electrode region and the drain electrode region is formed between oppositely disposed corners (31, 33) of the respective, line-like, potential barriers (30, 32).

26. Field effect transistor in accordance with claim 19, characterized in that two gate electrode regions (34, 36) are provided the adjacent, mutually oppositely disposed sides of which form the channel region (44) extending between the source electrode region (46) and the drain electrode region (48), and diverge from one another in the direction of the potential gradient.

27. Field effect transistor in accordance with one of the preceding claims 19 to 26, characterized in that the semiconductor structure comprises a III-V compositional semiconductor.

28. Field effect transistor in accordance with claim 27, characterized in that the compositional semiconductor is AlₓGa₁₋ₓAs, with the 2D-charge carrier layer being a 2D electron gas.

29. Field effect transistor in accordance with claim 28, characterized in that the 2D electron gas is located in the boundary region between an undoped Al_{0,3}Ga_{0,7}As layer (20) with a thickness smaller than 50 nm (500 Å), preferably approximately 20 nm (200 Å) and an undoped thicker layer (18) of GaAs, with the electrons originating from a doped layer (22) arranged on the side of the Al_{0,3}Ga_{0,7}As layer remote from the GaAs layer, for example from a layer of Al_{0,3}Ga_{0,7}As of approximately 50 nm (500 Å) thickness, which is n-doped with Si atoms at a concentration of approximately 10¹⁸cm⁻³.

30. Field effect transistor in accordance of the preceding claims 19 to 29, characterized in that the surface of the semiconductor structure is a [100] surface in Miller indices.

31. Integrated or highly integrated circuit consisting of one or more field effect transistors in accordance with claim 19, characterized in that the lateral potential barriers in the 2D-charge carrier layer define both active components, such as field effect transistors, and passive components, such as resistors or inductors, through electrode and channel regions, with electrode regions of neighbouring components which are connected to one another being in a conductive connection with one another via the 2D-charge carrier layer which is located therebetween; and in that the conductivity of the channel regions of the active components can be modified by the application of suitable control potentials to the neighbouring gate electrode regions; and in that, for the external connections to the circuit, one produces a contact to the 2D-charge carrier layer in selected electrode regions.

## Revendications

1. Procédé de production d'une structure active semi-conductrice, au moyen d'une structure semi-conductrice de sortie, qui présente en parallèle à la surface (10) une couche à porteur de charge bidimensionnelle, procédé dans le cas duquel on traite la structure de sortie pour établir des barrières de potentiel latérales de forme linéaire (30, 32) dans la couche à porteur de charge bidimensionnelle et pour ainsi subdiviser celle-ci en zones et dans le cas duquel il est prévu des contacts avec ces zones de la couche à porteur de charge bidimensionnelle, caractérisé en ce que, pour produire un transistor à effet de champ la subdivision en zones a lieu d'une manière telle qu'il se forme au moins une zone (34), fermée latéralement par une première barrière de potentiel de forme linéaire, de la couche à porteur de charge bidimensionnelle, ainsi que des zones de source, de grille et de drain (46, 48) de la couche à porteur de charge bidimensionnelle, la zone de source (46) et la zone de drain (48) étant séparées l'une de l'autre par une barrière de potentiel (32) de forme linéaire, tout en étant cependant reliées l'une à l'autre par l'intermédiaire d'une zone de canal (44) de la couche à porteur de charge bidimensionnelle, laquelle s'étend entre la zone de grille (34) fermée latéralement et la deuxième barrière de potentiel de forme linéaire, la zone de grille latéralement fermée étant séparée de la zone de canal par la première barrière de potentiel de forme linéaire et des contacts étant établis avec la couche à porteur de charge bidimensionnelle de la zone de grille fermée latéralement ainsi qu'avec la couche à porteur de charge bidimensionnelle dans les zones de source et de drain (46, 48).

2. Procédé selon la revendication 1, caractérisé en ce que la zone de grille latéralement fermée de la couche à porteur de charge bidimensionnelle est une zone rectangulaire de la structure semi-conductrice de sortie, dont l'angle qui est tourné vers la zone centrale de la structure semi-conductrice de sortie est disposé en regard de la deuxième barrière de potentiel (32) de forme linéaire.

3. Procédé selon la revendication 2, caractérisé en ce que l'extrémité opposée à l'angle de la deuxième barrière de potentiel de forme linéaire (32), qui le cas échéant peut être sous la forme d'une ligne coudée à angle droit, délimite le canal (44) avec l'angle.

4. Procédé selon la revendication 2, caractérisé en ce que la deuxième barrière de potentiel de forme linéaire (32) s'étend à ses deux extrémités jusqu'à la limite latérale de la structure semi-conductrice de sortie et forme une seconde zone, fermée latéralement, de la couche à porteur de charge bidimensionnelle et en conséquence une deuxième grille (36), une liaison externe conductrice étant établie le cas échéant entre les deux grilles.

5. Procédé selon l'une des revendications précédentes, caractérisé en ce que la structure de sortie est convertie, par la formation de barrières latérales de potentiel de forme linéaire dans la couche à porteur de charge bidimensionnelle, en un circuit intégré ou à haut degré d'intégration, des éléments de circuit passifs étant également produits, en plus de la production de structures semi-conductrices actives, par exemple sous la forme de résistances et d'inductances par le passage de lignes correspondantes.

6. Procédé selon la revendication 5, caractérisé en ce que la structure semi-conductrice a au moins deux couches à porteur de charge bidimensionnelles se trouvant en parallèle à la surface (10) et qui présentent un certain écartement l'une par rapport à l'autre dans le sens perpendiculaire à la surface (10), en ce que les barrières de potentiel de forme linéaire sont produites par destruction d'une manière linéaire de la structure semi-conductrice de sortie, et en ce que la destruction de manière linéaire est réalisée de telle sorte qu'il se forme des liaisons électriques entre les couches à porteur de charge bidimensionnelles.

7. Procédé selon l'une des revendications précédentes, caractérisé en ce que l'on choisit comme structure semi-conductrice de sortie un semi-conducteur de liaison III-V.

8. Procédé selon la revendication 7, caractérisé en ce que l'on prend comme semi-conducteur de liaison de l'AlₓGa₁₋ₓAs, la couche à porteur de charge bidimensionnelle étant un gaz électronique bidimensionnel.

9. Procédé selon la revendication 8, caractérisé en ce que le gaz électronique bidimensionnel se trouve dans la zone frontière comprise entre une couche d'Al_{0,3}Ga_{0,7}As (20) non dopée ayant une épaisseur inférieure à 50 nm (500 angströms), et de préférence égale à environ 20 nm (200 angströms) et une couche plus épaisse (18) non dopée en GaAs, les électrons provenant d'une couche (22) dopée, disposée sur le côté, situé à l'opposé de la couche de GaAs, de la couche de Al_{0,3}Ga_{0,7}As, par exemple d'une couche en Al_{0,3}Ga_{0,7}As d'une épaisseur de 50 nm environ, (500 angströms), qui fait l'objet d'un dopage n avec des atomes de silicium qui ont une concentration d'environ 10¹⁸ cm⁻³.

10. Procédé selon l'une des revendications précédentes, caractérisé en ce que la surface (10) de la structure semi-conductrice de sortie est en indices de Miller une surface -[100].

11. Procédé selon l'une des revendications précédentes, caractérisé en ce que les barrières de potentiel de forme linéaire sont produites par la destruction de manière linéaire de la structure semi-conductrice de sortie au moyen d'un rayon ionisant focalisé, commandé par ordinateur.

12. Procédé selon l'une des revendications précédentes, caractérisé en ce que les barrières de potentiel latérales de forme linéaire sont produites dans la couche à porteur de charge bidimensionnelle par l'implantation d'ions, par exemple pour obtenir un dopage p de la structure semi-conductrice de sortie, dans lequel les porteurs de charge de la couche à porteur de charge bidimensionnelle sont des électrons.

13. Procédé selon l'une des revendications précédentes, caractérisé en ce que la production des barrières latérales de potentiel de forme linéaire a lieu dans la couche à porteur de charge bidimensionnelle par destruction d'une manière linéaire de la conductibilité de la structure de sortie, par bombardement de la structure semi-conductrice de sortie par des ions à travers un masque, ce masque étant soit produit sur la surface (10) de la structure semi-conductrice de sortie par le procédé de photolithographie connu en soi et étant enlevé ensuite après l'implantation d'ions, soit posé sous la forme d'un masque distinct de la structure semi-conductrice de sortie sur la surface (10) de la structure semi-conductrice de sortie, le masque étant dans les deux cas de préférence un masque métallique.

14. Procédé selon l'une des revendications 11 ou 13, caractérisé en ce qu'après la production des zones avec les barrières de potentiel de forme linéaire, on soumet la structure semi-conductrice de sortie à un traitement thermique, qui conduit à une restauration partielle de la destruction et à une définition plus fine des lignes isolantes qui se sont ainsi formées.

15. Procédé selon la revendication 5, caractérisé en ce que l'on établit pour les raccordements externes au circuit dans les zones sélectionnées des électrodes un contact avec la zone correspondante de la couche à porteur de charge bidimensionnelle.

16. Procédé selon la revendication 15, caractérisé en ce que les composants actifs comprennent des circuits logiques de grille, et les composants passifs comprennent des résistances et/ou des inductances.

17. Procédé selon l'une des revendications 15 ou 16, caractérisé en ce que les résistances sont formées par des zones longitudinales de la couche à porteur de charge bidimensionnelle.

18. Procédé selon l'une des revendications 15 à 17, caractérisé en ce que les inductances sont constituées par des zones en forme de méandres de la couche à porteur de charge bidimensionnelle.

19. Transistor à effet de champ, avec des électrodes de source, de drain et de grille (54, 56, 50, 52), consistant en une structure semi-conductrice avec une couche à porteur de charge bidimensionnelle qui s'étend en parallèle à sa surface (10), la structure semi-conductrice étant subdivisée par des barrières de potentiel (30, 32), latérales, de forme linéaire, dans la couche à porteur de charge bidimensionnelle, en des zones d'électrodes de source, de drain et de grille (46, 48, 34, 36) de la couche à porteur de charge bidimensionnelle et en une zone de canal (44), conductrice, qui se trouve au voisinage de la zone d'électrode de grille, la subdivision en zones ayant lieu de telle sorte qu'il y ait au moins une zone (34), formant la zone d'électrode de grille, fermée latéralement par une première barrière de potentiel de forme linéaire, de la couche à porteur de charge bidimensionnelle ainsi qu'une première et une deuxième autre zones (46, 48) formant la zone d'électrode de source ou de drain de la couche à porteur de charge bidimensionnelle, la zone d'électrode de source (46) et la zone d'électrode de drain (48) étant séparées l'une de l'autre par une deuxième barrière de potentiel de forme linéaire, tout en étant cependant reliées l'une à l'autre par la zone de canal (44) de la couche à porteur de charge bidimensionnelle, qui s'étend entre la zone (34) d'électrode de grille, fermée latéralement, et la deuxième barrière de potentiel de forme linéaire, la zone d'électrode de grille, fermée latéralement, étant séparée de la zone de canal par la première barrière de potentiel de forme linéaire, et en ce que la mise en contact des différentes zones d'électrode de source, de drain et de grille a lieu dans ces zones par des contacts correspondants (54, 56, 50, 52) avec la couche à porteur de charge bidimensionnelle.

20. Transistor à effet de champ selon la revendication 19, caractérisé en ce que la zone de canal (44) présente une largeur maximale d'environ 5 µm.

21. Transistor à effet de champ, selon l'une des revendications précédentes 19 à 20, caractérisé en ce que la zone de canal (44) est formée entre un côté ou un angle de la zone (34) d'électrode de grille et la seconde barrière de potentiel de forme linéaire (32) située en regard.

22. Transistor à effet de champ, selon la revendication 21, caractérisé en ce que la zone de canal (44) est formée par la limite latérale de la zone d'électrode de grille (34) et l'extrémité de la seconde barrière de potentiel (32), de forme linéaire, qui peut être le cas échéant constituée sous la forme d'une ligne coudée à angle droit.

23. Transistor à effet de champ, selon l'une des revendications précédentes 19 à 22, caractérisé en ce que les barrières de potentiel de forme linéaire sont en une matière isolante, en ce que la deuxième barrière de potentiel de forme linéaire forme une deuxième zone d'électrode de grille, fermée latéralement, en ce que la zone de canal (44) est formée entre les deux zones d'électrodes de grille (34, 36), séparées, entourées d'une matière isolante (30, 32), et en ce que le cas échéant il est prévu une liaison externe conductrice entre ces deux électrodes de grille.

24. Transistor à effet de champ, selon l'une des revendications 19 à 21, caractérisé en ce que la zone d'électrode de grille (34) est délimitée par une barrière de potentiel de forme linéaire (32) en matière isolante, qui s'étend à ses deux extrémités jusqu'à la limite latérale de la structure semi-conductrice, et en ce que les zones d'électrodes de source et de drain (46, 48) sont formées sur des côtés opposés de la barrière de potentiel, de forme linéaire, (32) en matière isolante, cette barrière de potentiel (32) de forme linéaire s'étendant à l'une de ses extrémités également jusqu'à la limite latérale de la structure semi-conductrice.

25. Transistor à effet de champ, selon la revendication 19, caractérisé en ce que l'on prévoit deux zones d'électrodes de grille (34, 36), dont l'une peut être raccordée à la zone de source (46), les deux zones d'électrodes de grille (34, 36) étant délimitées par des barrières de potentiel latérales, de forme linéaire, correspondantes, dans la couche à porteur de charge bidimensionnelle, dont chacune s'étend autour d'au moins un angle et en ce que les zones de canal (44), qui relient les zones d'électrodes de source et les zones d'électrodes de drain, sont formées entre des angles se faisant vis à vis (31, 33) des barrières de potentiel de forme linéaire, (30, 32) respectives.

26. Transistor à effet de champ, selon la revendication 19, caractérisé en ce que l'on prévoit deux zones d'électrodes de grille (34, 36), dont des côtés voisins, opposés l'un à l'autre, formant la zone de canal (44), qui s'étend entre la zone d'électrode de source (46) et la zone d'électrode de drain (48), s'écartent l'un de l'autre dans le sens du gradient de tension.

27. Transistor à effet de champ, selon l'une des revendications précédentes 19 à 26, caractérisé en ce que la structure semi-conductrice consiste en un semi-conducteur de liaison III-V.

28. Transistor à effet de champ, selon la revendication 27, caractérisé en ce que le semi-conducteur de liaison est en AlₓGa₁₋ₓAs, la couche à porteur de charge bidimensionnelle étant un gaz électronique bidimensionnel.

29. Transistor à effet de champ, selon la revendication 28, caractérisé en ce que le gaz électronique bidimensionnel se trouve dans la zone frontière entre une couche d'Al_{0,3}Ga_{0,7}As (20) non dopée ayant une épaisseur inférieure à 50 nm (500 angströms), et de préférence égale à environ 20 nm (200 angströms) et une couche plus épaisse (18) non dopée en GaAs, les électrons provenant d'une couche (22) dopée, disposée sur le côté, situé à l'opposé de la couche de GaAs, de la couche de Al_{0,3}Ga_{0,7}As, par exemple d'une couche en Al_{0,3}Ga_{0,7}As d'une épaisseur de 50 nm environ, (500 angströms), qui fait l'objet d'un dopage n avec des atomes de silicium qui ont une concentration d'environ 10¹⁸ cm⁻³.

30. Transistor à effet de champ, selon l'une des revendications précédentes 19 à 29, caractérisé en ce que la surface de la structure semi-conductrice est en indices de Miller une surface [100].

31. Circuit intégré ou circuit à haut degré d'intégration, consistant en plusieurs transistors à effet de champ selon la revendication 19, caractérisé en ce que la barrière latérale de potentiel dans la couche à porteur de charge bidimensionnelle comprend aussi bien des composants actifs, tels qu'un transistor à effet de champ, que des composants passifs, tels que des résistances ou des inductances, définis par des zones d'électrodes ou des zones de canaux, les zones d'électrodes raccordées les unes aux autres de composants voisins se trouvant en liaison conductrice les unes avec les autres par l'intermédiaire de la couche à porteur de charge bidimensionnelle, qui se trouve entre, et la conductibilité des zones de canaux des composants actifs pouvant être modifiée en appliquant des tensions appropriées aux zones voisines d'électrodes de grille, et en ce que l'on établit pour les raccordements externes au circuit dans les zones sélectionnées d'électrodes un contact avec la couche à porteur de charge bidimensionnelle.
